# EUROPÄISCHE PATENTSCHRIFT

(11) **EP 2 432 850 B1**
(45) Veröffentlichungstag und Bekanntmachung des Hinweises auf die Patenterteilung: **25.07.2018**
(21) Anmeldenummer: 10720619.5
(22) Anmeldetag: 20.05.2010
(51) Int. Cl.: D06N 3/18, D06M 15/63, D06N 7/00, D06P 1/00, H01L 51/00, H01L 51/56, H01L 27/32

(54) **ELEKTROLUMINESZIERENDES TEXTIL UND VERFAHREN ZU DESSEN HERSTELLUNG**
ELECTROLUMINESCENT TEXTILE AND METHOD FOR THE PRODUCTION THEREOF
TEXTILE ÉLECTROLUMINESCENT ET PROCÉDÉ DE FABRICATION ASSOCIÉ

(30) Priorität: 20.05.2009 DE 102009026409
(43) Veröffentlichungstag der Anmeldung: 28.03.2012
(73) Patentinhaber: Hochschule Niederrhein, 47805 Krefeld (DE)
(72) Erfinder: RABE, Maike, 41648 Neuss (DE); LEMPA, Evelyn, 47803 Krefeld (DE); STEINEM, Christine Maria, 41061 Mönchengladbach (DE)
(74) Vertreter: Michalski Hüttermann & Partner Patentanwälte mbB
(86) Internationale Anmeldenummer: PCT/EP2010/056992
(87) Internationale Veröffentlichungsnummer: WO 2010/133681

(56) Entgegenhaltungen:
- WO-A1-98/30069
- WO-A1-2009/030701
- WO-A1-2009/039878
- WO-A2-98/07136
- DE-T2- 69 729 867
- US-A- 5 976 613
- US-A1- 2005 248 268

## Beschreibung

Die Erfindung betrifft das Gebiet lumineszierender Textilien. Insbesondere betrifft die Erfindung ein Verfahren zur Herstellung elektrolumineszierender Textilien sowie entsprechend hergestellte elektrolumineszierende Textilien.

Lumineszenz bezeichnet einen Prozess, bei dem ein Atom Energie aufnimmt und durch Abstrahlung eines Photons wieder abgibt. Unter Elektrolumineszenz versteht man die direkte Lumineszenzanregung von Leuchtpigmenten bzw. Luminophoren oder Halbleiterkristallen durch ein elektrisches Wechsel- oder Gleichstromfeld. Die Elektrolumineszenztechnologie hat in jüngerer Zeit zunehmend an Bedeutung gewonnen und ermöglicht die Realisierung blend- und schattenfreier, homogener Leuchtflächen.

Auch elektrolumineszierende Textilien sind im Stand der Technik bekannt und weisen breite Anwendungsmöglichkeiten auf, für Beleuchtungszwecke oder bei dekorativen Textilien, insbesondere bei Sicherheitsbekleidung.

Herstellbar sind elektrolumineszierende Textilien beispielsweise durch Integration elektrisch leitfähiger Filamente oder Garne. Beispielsweise offenbart die Schrift DE 10 2004 007 365 A1 eine textile Flächenstruktur aus einer Anordnung einer Vielzahl von leitfähigen Fäden. Die Flexibilität derartiger elektrolumineszierender Textilien ist jedoch eingeschränkt. Darüber hinaus sind die Gestaltungsmöglichkeiten durch den Einbau der elektrisch leitfähigen Filamente beschränkt, die weiterhin frühzeitig in das entstehende Textil eingearbeitet werden müssen. Zudem können elektrolumineszierende Textilien die textilübliche Haptik verlieren, insbesondere bei Verwendung einer Vielzahl elektrisch leitfähiger Filamente.

Weiter offenbart die Schrift WO 2009/030701 eine zweiteilige Elektrolumineszenz-Anordnung aus einem Elektrolumineszenz-Element und einem textilen Trägermaterial. Diese Anordnung wird durch einen Haftverbund beispielsweise aus TPU (Thermoplastisches Polyurethan) verbunden, indem auf das textile Trägermaterial beispielsweise eine TPU-Folie auflaminiert und auf diese die separat hergestellte Einheit einer Elektrolumineszenz-Schichtanordnung aufgebracht wird. Schwachstellen oder Fehler des Laminierens können jedoch dazu führen, dass der Zusammenhalt eines derartigen über eine Haftschicht verbundenen Laminats gestört ist, wodurch der Beleuchtungseffekt an diesen Stellen gestört ist. Weiterhin können auch mechanische Einwirkungen oder eine Alterung des Haftverbunds zu einer Ablösung des Elektrolumineszenz-Elements von dem textilen Trägermaterial führen. Aufgabe der Erfindung war es daher, wenigstens einen Nachteil des Standes der Technik zu überwinden. Insbesondere war es Aufgabe der Erfindung elektrolumineszierende Textilien mit verbesserter Flexibilität zur Verfügung zu stellen.

Erfindungsgemäß wird die Aufgabe gelöst durch ein Verfahren zur Herstellung eines elektrolumineszierenden Textils gemäß Anspruch 1 der vorliegenden Erfindung.

Ein weiterer Gegenstand der Erfindung betrifft ein elektrolumineszierendes Textil gemäß Anspruch 5. Weitere vorteilhafte Ausgestaltungen der Erfindung ergeben sich aus den Unteransprüchen.

Erfindungsgemäß wird auf das bereitgestellte Textilsubstrat eine elektrolumineszierende Schichtanordnung aufgebracht. Die elektrolumineszierende Schichtanordnung ermöglicht die Herstellung eines Textils, dessen elektrolumineszierende Materialien nach Anlegen einer Wechselspannung zum Leuchten anregbar sind, wodurch ein selbstleuchtendes Textil entsteht.

Die elektrolumineszierende Schichtanordnung in Sinne der vorliegenden Erfindung umfasst vorzugsweise wenigstens eine erste leitfähige Schicht, eine lichtemittierende Schicht, eine dielektrische Schicht und eine zweite leitfähige Schicht. Optional kann die elektrolumineszierende Schichtanordnung wenigstens eine Schutzschicht umfassen.

Es wurde überraschend gefunden, dass mit dem erfindungsgemäßen Verfahren elektrolumineszierende Textilien herstellbar sind, die eine gute textile Flexibilität zur Verfügung stellen können. Insbesondere können die mit dem erfindungsgemäßen Verfahren herstellbaren elektrolumineszierenden Textilien in vorteilhafter Weise die textilübliche Haptik bewahren.

Ein weiterer bedeutender Vorteil der mit dem erfindungsgemäßen Verfahren herstellbaren elektrolumineszierenden Textilien liegt darin, dass die elektrolumineszierende Schichtanordnung insbesondere die Schutzschicht oder die erste transparente leitfähige Schicht erfindungsgemäß direkt auf das Textil aufgebracht wird. Hierdurch werden das Textil und die elektrolumineszierende Schichtanordnung fest und nicht lösbar miteinander verbunden. Es wird somit ein einteiliges elektrolumineszierendes Produkt hergestellt. Dies kann in vorteilhafter Weise Störungen des Leuchteffektes durch einen gestörten Zusammenhalt des Textilsubstrats und der elektrolumineszierenden Schichtanordnung vermeiden, wie sie durch Fehler beim Aufbringen einer Haftvermittlerschicht oder einer Alterung des Haftvermittlers auftreten können. Weiterhin hat ein einteiliges elektrolumineszierendes Textil den großen Vorteil, dass die elektrolumineszierende Schichtanordnung nicht Gefahr läuft, von dem Textil abgetrennt zu werden, wie dies beispielsweise bei einer auflaminierten Anordnung leicht passieren kann.

Darüber hinaus erübrigt sich bei dem erfindungsgemäßen Verfahren der Verfahrensschritt des Auflaminierens der elektrolumineszierenden Schichtanordnung, wodurch das Verfahren eine kostengünstigere Herstellung elektrolumineszierender Textilien erlaubt. Zudem wird das Herstellungsverfahren deutlich vereinfacht, da die elektrolumineszierende Schichtanordnung nicht zunächst gesondert hergestellt und in einem zusätzlichen Schritt mit dem Substrat verklebt werden muss. Ferner wird die Flexibilität der mit dem erfindungsgemäßen Verfahren hergestellten elektrolumineszierenden Textilien nicht durch eine Haftvermittlerschicht verringert.

Die Anordnung der einzelnen Schichten erfolgt erfindungsgemäß derart, dass die elektrolumineszierende Schichtanordnung auf der späteren Rückseite, des Textils erfolgt, wodurch der Effekt erzielt werden kann, dass die Textile "von innen her" leuchten. Eine Anordnung der elektrolumineszierenden Schichtanordnung auf der Rückseite des Textils hat wesentliche Vorteile. Dies ermöglicht zum Einen, dass die Vorderseite des Textils für die Gestaltung von Motiven und/oder eine weiterführende farbliche Gestaltung des Textils zur Verfügung steht. Zum anderen ermöglicht eine elektrolumineszierende Schichtanordnung auf der Rückseite des Textils, dass die Struktur des Textils in die Leuchtwirkung einbezogen werden kann, da dieses nicht nur als Untergrund dient, sondern der Leuchtweg durch das Textil hindurch führt.

Weiter ermöglicht dies eine einfachere Auftragung der einzelnen Schichten, da beispielsweise die vordere Elektrode, eine transparente leitfähige Schicht, direkt auf die Oberfläche des Textilsubstrats oder eine darauf befindliche Schutzschicht aufgetragen wird und optional aufgetragene nichttransparenten Schichten darunter angeordnet sind.

Dadurch, dass die Vorderseite des Textils für die Gestaltung von Motiven und/oder eine weiterführende farbliche Gestaltung des Textils zur Verfügung steht, bieten sich viele Möglichkeiten der Gestaltung der elektrolumineszierenden Textilien. Insbesondere die Motivgestaltung kann eine sehr wichtige Rolle spielen.

Farb- und Designeffekte können beispielsweise weiterhin durch die Verwendung von Leuchtpigmenten in der lichtemittierenden Schicht umgesetzt werden. Diese können einfarbig oder mehrfarbig leuchtend aufgebracht werden. Weiterhin können Farb- und Designeffekte durch ein vorheriges Bedrucken der Vorderseite des textilen Trägers beispielsweise mittels Pigmentdruck umgesetzt werden. Auch hierbei können einfarbige oder mehrfarbige Designs verwendet werden. Durch die Kombinationen und das Zusammenspiel von farbig bedruckter Oberfläche und Leuchtfarben aus dem Textil heraus können wiederum unterschiedlichste Wirkungen hervorgerufen werden.

Die herstellbaren Farb- und Leuchteffekte ermöglichen insbesondere in ihrer Kombination eine große Gestaltungsfreiheit. Beispielsweise besteht die Möglichkeit, ein farbiges Motiv, das auch ohne Beleuchtung in Tageslicht zu sehen ist, mit einem Leuchtmotiv, das durch Beleuchtung insbesondere während der Nacht hervortritt, zu kombinieren. Dies ist insbesondere vorteilhaft verwendbar für Jalousien, Blendschutze, Rollos, Lampenschirme und ähnliches für beispielsweise Restaurants, Hotels, Arztpraxen oder Kinderzimmer.

Die Materialien der einzelnen Schichten sind in Form kommerziell erhältlicher Pasten, beispielsweise so genannter Elektrolumineszenz(EL)-Pasten, auftragbar. Die Verwendung der Elektrolumineszenz(EL)-Pasten ermöglicht insbesondere ein Aufbringen der Schichten in Form einer Beschichtung oder eines Drucks. Geeignete Pasten sind beispielsweise unter der Handelsbezeichnung Ormecon® EL bei der Firma Ormecon erhältlich. Entsprechende Pastensysteme umfassen leitfähige, isolierende und lumineszierende Pasten, welche die Herstellung einer flexiblen elektrolumineszierenden Schichtanordnung auf textilen Trägermaterialien ermöglichen.

Die Verwendung von Elektrolumineszenz-Pasten zum direkten Auftrag von Elektrolumineszenz auf Textilien bietet eine Vielzahl von vorteilhaften Eigenschaften. Die Pasten bilden vorzugsweise stabile Dispersionen mit geringem Absetzverhalten aus und können eine gute Haftfähigkeit an verschiedene Trägermaterialien zeigen, welches den Einsatz auf Textilien unterstützt. Des Weiteren können sie eine textilnahe Verarbeitung, schnelles Trocknen bei geringen Temperaturen und eine hohe Lichtausbeute im fertigen Produkt zur Verfügung stellen. Elektrolumineszenz-Pasten bieten insbesondere die Möglichkeit, in dünnen Schichten direkt auf ein textiles Material aufgetragen zu werden, wodurch der textile Charakter annähernd erhalten werden kann. Weiter ist von Vorteil, dass das Beschichten mit elektrolumineszenten Pasten auf bereits bestehenden Maschinen durchgeführt werden kann, die üblicher Weise zur Beschichtung von Textilien mit Polymeren für spezielle Funktionalisierungen verwendet werden.

In bevorzugten Ausführungsformen des Verfahrens erfolgt das Aufbringen der jeweiligen Schicht durch kontinuierliches oder diskontinuierliches Beschichten, oder durch kontinuierliches oder diskontinuierliches Drucken.

Besonders bevorzugt ist das Aufbringen der Schichten durch kontinuierliches oder diskontinuierliches Beschichten. Ein Beschichten erfolgt vorzugsweise durch Streichen, Rakeln, Rollen, Walzen, Spritzen oder Tauchen. Weiter ist von Vorteil, dass ein Beschichten eine direkte Auftragung ohne Schablone ermöglicht. Bevorzugt ist das Verfahren der Direktbeschichtung, bei der die Beschichtungsmasse direkt auf das Textilsubstrat aufgerakelt wird. In vorteilhafter Weise ist die Breite, in welcher eine Paste aufgetragen wird, abhängig von der Beschaffenheit der verwendeten Beschichtungsmaschine, stufenlos regelbar. Bei allen Auftragssystemen kann die Breite mit Hilfe von manuell oder motorisch verstellbaren Seitenbegrenzungen variiert werden. Ergänzend können durch Beschichtung Seitenbegrenzungen und/oder eine Vorderplatte hinzugefügt werden, welche das Pastenbecken geschlossen halten. Dieser Zusatz ist insbesondere bei niedrig viskosen Beschichtungspasten vorteilhaft, da verhindert werden kann, dass diese an der Ware entlang verlaufen. Bevorzugt ist eine Beschichtung mit Walzen- oder Luftrakeln.

Es ist von großem Vorteil, dass das Beschichten eine präzise Definition der aufzutragenden Schichten erlaubt. Durch ein Beschichten sind deutlich dünnere und gleichmäßige Schichtdicken, die für eine gute Funktionsfähigkeit eines elektrolumineszierenden Textils von großer Bedeutung sind, auftragbar.

Auch bevorzugt ist das Aufbringen der Schichten durch kontinuierliches oder diskontinuierliches Drucken, vorzugsweise durch Direktdruckverfahren ausgewählt aus der Gruppe umfassend Siebdruck, Rouleauxdruck, Digitaldruck und/oder Transferdruck. Diese bieten verschiedene Möglichkeiten, die Schichten oder Pasten auf ein Textil aufzubringen. Unter dem Begriff "Direktdruck" wird im Sinne der vorliegenden Erfindung das direkte Aufdrucken auf den jeweiligen Untergrund verstanden.

Besonders bevorzugt ist der Siebdruck, auch Film- oder Schablonendruck genannt. Hierdurch lassen sich die Pasten sehr einfach und homogen auftragen. Insbesondere eine homogene Auftragung ist von großer Bedeutung für eine gleichmäßige Leuchtwirkung des Textils. Weiter ist von Vorteil, dass mittels Siebdruck auftragbare Muster frei wählbar sind, insbesondere sind mittels Siebdruck auch großrapportige oder kontinuierliche Muster auftragbar. In vorteilhafter Weise sind durch Siebdruck beim Drucken mit Schablonen komplexe Musterbildungen möglich.

Üblicher Weise erfolgt bei der Aufbringung der Schichten durch Beschichtungsverfahren das Aufbringen einer vollflächigen Schicht. Das Ausbilden eines Musters erfolgt bei Verwendung von Beschichtungsverfahren vorzugsweise durch Aufbringen eines Motivs auf die unbeschichtete Textilseite, beispielsweise durch Pigmentdruck. Bevorzugt erfolgt ein solcher Druck, bevor die elektrolumineszierende Schichtanordnung auf der Rückseite des Textils aufgebracht wird.

In bevorzugten Ausführungsverfahren umfasst das Verfahren das Aufbringen eines Motivs, vorzugsweise durch Drucken und/oder Färben, auf eine zweite Oberfläche des Textilsubstrats. Die zweite Oberfläche des Textilsubstrats ist vorzugsweise die Vorderseite des elektrolumineszierenden Textils. Bevorzugt umfasst das Verfahren einen Druck auf die Vorderseite des Textilsubstrats.

Die Gestaltung des elektrolumineszierenden Textils auf der Substratvorderseite kann durch Färbung und/oder Druck erreicht werden. Ein Zusammenspiel der Farben des Textilsubstrats und einem möglichen Textildruck mit der Lichtfarbe der möglichen verschiedenen Luminophore kann dabei völlig neue Effekte erreichen. Das Licht kann partiell durch das Motiv hindurch scheinen oder wird durch das Muster abgedeckt, welches bei Anschluss an eine Spannungsquelle von hinten beleuchtet wird.

Die Gestaltung der Muster im Vorfeld, insbesondere mit Hilfe von verschiedenen Textildrucken auf der Vorderseite, bietet sehr hohe Variationsmöglichkeiten, da prinzipiell jedes gewünschte Motiv aufgedruckt werden kann. Somit wird eine Gestaltung der Muster mit hoher Variationsmöglichkeit erlaubt. Auf diese Art kann jede gewünschte Form und jedes Motiv aufgebracht werden. Beispielsweise kann das Motiv ausgewählt sein aus der Gruppe umfassend ein oder mehrere Bild(er), Wort(e), Logo(s) und/oder Piktogramm(e).

Das Textil kann vor dem Beschichten entsprechend der Faserart durch bekannten Färbe- und Druckverfahren gestaltet werden. Hierbei kann der Druck durch übliche Fixierbedingungen auf dem Textil fixiert werden. Das Textilsubstrat wird vorzugweise vor dem Aufbringen der elektrolumineszierenden Schichtanordnung vorbehandelt. Beispielsweise kann das Textilsubstrat vor dem Beschichten durch eine Wärmebehandlung, Thermofixieren genannt, fixiert werden. Eine solche Vorbehandlung kann sicherstellen, dass das textile Substrat bestmöglich dimensionsstabil vorliegt und Dimensionsänderungen während des Beschichtens oder Zwischentrocknens weitestgehend ausgeschlossen werden können.

Eine bevorzugte Vorbehandlung ist je nach Faserart das Waschen des Textils, um sowohl Verunreinigungen, als auch eventuelle Präparationen, oder Schlichtereste zu entfernen, die das Beschichtungsergebnis verfälschen oder die Aufnahme der Paste behindern könnten.

Grundsätzlich ist jedes textile Substrat verwendbar. Geeignete textile Substrate sind beispielsweise ausgewählt aus der Gruppe umfassend Gewebe, Vlies, Gewirke oder einer Kombination hiervon. Geeignete Textilmaterialien sind beispielsweise Pflanzenfasern, Fasern tierischen Ursprungs, Mineralfasern geologischen Ursprungs, Chemiefasern, Fasern aus synthetischen Polymeren, anorganische Chemiefasern oder Kunstleder. Geeignete Textilmaterialien sind bevorzugt Baumwolle, Seide, Leinen und/oder Synthesefasern beispielsweise ausgewählt aus der Gruppe umfassend Polyamid, Polyacryl, Elasthan, Polyester und/oder Polyethylen. Diese Materialien sind im Sinne der Erfindung bevorzugt unter dem Begriff "Textil" zu verstehen. Hierbei sind dichtere und/oder festere textile Substrate für einen Druck oder eine Beschichtung vorteilig. Besonders bevorzugt ist ein sehr dichtes Gewebe aus Polyester. In vorteilhafter Weise können auf dieses Gewebe die Pasten, beispielsweise erhältlich bei der Fa. Ormecon, sehr gut aufgetragen werden.

Textilien, die durchlässiger, weniger dicht gewebt oder sehr aufnahmefähig sind, können im Vorfeld vorzugsweise mit einer Schutzschicht versehen werden, welche die beschichtete Seite des Textils undurchlässig und dicht macht, den textilen Charakter der anderen Seite jedoch unverändert lässt.

Ein weiterer optionaler Schritt des Verfahrens ist das Aufbringen einer Schutzschicht auf eine erste Oberfläche des Textilsubstrats. Die erste Oberfläche des Textilsubstrats ist vorzugsweise die hintere Oberfläche, die spätere Rückseite, des Textils. In anderen Ausführungsformen kann die erste Oberfläche des Textilsubstrats die spätere Vorderseite des Textils sein. In dieser Ausführungsform befindet sich die elektrolumineszierende Schichtanordnung auf der späteren Vorderseite des Textils.

Das Aufbringen einer Schutzschicht kann als Schutz insbesondere vor dem unerwünschten Durchtränken des Gewebes mit der aufzutragenden Schicht dienen. Das Aufbringen der Schutzschicht erfolgt vorzugsweise vor dem Aufbringen der elektrolumineszierenden Schichtanordnung auf das Textilsubstrat. Das Aufbringen der Schutzschicht ist vorzugsweise ein einseitiges Beschichten. In vorteilhafter Weise ist eine solche Schutzschicht kaum oder nicht fühlbar und erhält die textile Eigenschaft. Die Schichtdicke der Schutzschicht liegt vorzugsweise im Bereich von ≥ 0,5 µm bis ≤ 10 µm, vorzugsweise im Bereich von ≥ 1 µm bis ≤ 5 µm. Das Aufbringen einer Schutzschicht bietet in besonders vorteilhafter Weise die Möglichkeit, jegliche Arten von Textilien als Substrat verwenden zu können.

Es kann weiter vorgesehen sein, dass eine weitere Schutzschicht auf die zweite Oberfläche des Textilsubstrats aufgebracht wird. Die zweite Oberfläche des Textilsubstrats ist vorzugsweise die vordere Oberfläche, die spätere Vorderseite, des Textils. Eine solche Beschichtung kann als Schutz vor äußeren Einflüssen, insbesondere gegen Wasser und Trockenschmutz in der Atmosphäre dienen. Die Schichtdicke der äußeren Schutzschicht liegt vorzugsweise im Bereich von ≥ 0,5 µm bis ≤ 10 µm, vorzugsweise im Bereich von ≥ 1 µm bis ≤ 5 µm.

Bevorzugte Materialien der Schutzschicht sind Polymere ausgewählt aus der Gruppe umfassend Silikone, Polyurethane, Polyvinylchlorid, Polysulfide und/oder Acrylate, vorzugsweise ausgewählt aus der Gruppe umfassend Silikone und/oder Polyurethane. In besonders bevorzugten Ausführungsformen umfasst das Aufbringen einer Schutzschicht auf die erste Oberfläche, vorzugsweise die spätere Rückseite, des Textilsubstrats das Aufbringen eines Polyurethans. Weiter bevorzugt umfasst das Aufbringen einer Schutzschicht auf die zweite Oberfläche, vorzugsweise die spätere Vorderseite, des Textilsubstrats das Aufbringen eines Silikons.

Auf die erste Oberfläche, vorzugsweise die spätere Rückseite des Textilsubstrats, oder die optional aufgebrachte Schutzschicht bringt man in einem nächsten Schritt eine transparente leitfähige Schicht, vorzugsweise möglichst ganzflächig, auf. Die transparente leitfähige Schicht wird auch als Frontelektrode bezeichnet. Die Transparenz oder Lichtdurchlässigkeit ist von großer Bedeutung, denn neben der Stromleitung ermöglicht diese Schicht dem Licht, welches aus der lichtemittierenden Schicht emittiert wird, nach außen abzustrahlen.

Bevorzugt verwendbar zur Ausbildung der transparenten leitfähigen Schicht sind leitfähige transparente Polymere, vorzugsweise Polyethylen-Dioxithiophen (PEDT). Weiter kann die leitfähige Schicht aus transparenten leitfähigen Materialien wie Indium-Zinnoxid ausgebildet werden. Die transparente leitfähige Schicht kann weiter aus einem Polyesterfilm, welcher mit Indium-Zinnoxid (ITO, Indium Tin Oxide) oder einem anderen leitfähigen Polymer beschichtet ist, ausgebildet sein. Indium-Zinnoxid ist elektrisch leitfähig, sowie transparent und kann in vorteilhafter Weise eine hohe Lichttransmission der elektrolumineszierenden Schichtanordnung unterstützen.

Bevorzugt verwendbar ist eine transparente leitfähige Paste aus einer 3,4 Polyethylen-Dioxithiophen (PEDT)-Dispersion auf Basis eines synthetischen Polymers. Eine entsprechende leitfähige Paste ist beispielsweise unter der Bezeichnung Ormecon® EL 5602 bei der Firma Ormecon erhältlich.

Ein besonders gutes Leuchtergebnis, insbesondere ein flächiges Leuchten kann erzeugt werden, wenn die transparente leitfähige Schicht oder Frontelektrode möglichst dünn aufgetragen wird. In bevorzugten Ausführungsformen bringt man die transparente leitfähige Schicht mit einer Schichtdicke im Bereich von ≥ 2 µm bis ≤ 15 µm, vorzugsweise im Bereich von ≥ 5 µm bis ≤ 12 µm, bevorzugt im Bereich von ≥ 8 µm bis ≤ 10 µm, auf.

Weiter weist die transparente leitfähige Schicht oder Frontelektrode vorzugsweise eine Flächenabdeckung im Bereich von ≥ 300 cm²/g bis ≤ 400 cm²/g, bevorzugt von ≥ 350 cm²/g auf.

Gemäß einem bevorzugten Verfahren bringt man auf die transparente leitfähige Schicht in einem nächsten Schritt wenigstens eine lichtemittierende Schicht, vorzugsweise mittig, auf. Unter dem Begriff "lichtemittierende Schicht" ist im Sinne der Erfindung eine Schicht zu verstehen, die ein Material enthält, das zur Elektrolumineszenz fähig ist, beispielsweise Leuchtpigmente. Hierbei wird vorzugsweise ein definierter Rand an den Seiten der Frontelektrode in einer Breite von jeweils mindestens 2 cm freigelassen. Die lichtemittierende Schicht ist für die Elektrolumineszenz des Textils von grundlegender Bedeutung. Besonders bevorzugt verwendbar zur Ausbildung der lichtemittierenden Schicht sind organische lichtemittierende Polymere oder anorganische Materialien. Bevorzugt sind anorganische lichtemittierende Materialien.

Vorzugsweise wird die Lumineszenz durch so genannte Leuchtpigmente, die in ein Bindemittel eingebettet sind, vermittelt. Die Leuchtpigmente sind vorzugsweise binäre Verbindungen, für die lumineszenzfähige Stoffe, Luminophore und Phosphore, verwendet werden. Diese Bestandteile gehören zur Gruppe der lichttragenden (griechisch: phosphoros), nachleuchtenden (Luminophor) und lichtemittierenden (Fluoreszenz) Elemente, welche durch Bestrahlung mit kurzwelligem Licht, UV-, Röntgen- oder Elektronenstrahlen angeregt werden können. Die lichtemittierende Schicht kann auch als Leuchtmittelschicht oder Phosphorschicht bezeichnet werden. Die lichtemittierende Schicht umfasst in bevorzugten Ausführungsformen Leuchtpigmente, die in einem organischen oder keramischen Bindemittel eingebettet sind.

Bevorzugte Leuchtpigmente sind Phosphore auf Basis von anorganischem SiC und/oder ZnS, die mit Metallen vorzugsweise ausgewählt aus der Gruppe umfassend Cu, Mn, Ag, Au, Pb, P, As, Sb, Sn, V, Tl, Sc, Cr und/oder seltene Erden dotiert werden. Diese Dotierung von ZnS oder SiC mit Fremdatomen kann zu unterschiedlichen Farberscheinungen führen. Insbesondere können der Farbton bzw. die Wellenlängenbereiche des emittierten Lichtes, durch das Dotierungselement bestimmt werden.

Bei Verwendung von Beschichtungstechniken wird eine oder mehrere lichtemittierende Schichten aufgetragen. Bei Verwendung von Drucktechniken können neben dem Auftrag von einer, zwei oder mehreren lichtemittierenden Schichten auch Schablonen mit unterschiedlichen Mustern und Formen verwendet werden. In vorteilhafter Weise lassen sich auch mittels Digitaldruck eine oder mehrere lichtemittierende Schichten in unterschiedlichen Mustern und Formen aufbringen. Von Vorteil ist hierbei insbesondere, dass sich über Düsen das digitale Design gut auf das Textil übertragen lässt. Dies führt in vorteilhafter Weise zu einer Erhöhung der Variationsmöglichkeiten zur farblichen und Muster-Gestaltung des elektrolumineszierenden Textils.

Die lichtemittierende Schicht kann flächig oder in Form gewünschter Motive und/oder ein- oder mehrfarbig aufgebracht werden. Insbesondere können in der lichtemittierenden Schicht durch Verwendung eines oder mehrerer verschiedenfarbige Leuchtpigmente enthaltenden Leuchtmittel Motive erstellt werden.

Insbesondere eine Verwendung von Drucktechniken zum Aufbringen der lichtemittierenden Schicht bietet sehr hohe Variationsmöglichkeiten zur Gestaltung eines Musters und/oder zur farblichen Gestaltung. In vorteilhafter Weise kann beispielsweise über Siebdruck jedes gewünschte Motiv, insbesondere geometrische Muster oder Buchstabenfolgen aufgedruckt werden. Beispielsweise kann das Motiv ausgewählt sein aus der Gruppe umfassend ein oder mehrere Bild(er), Wort(e), Logo(s) und/oder Piktogramm(e). Weiter können durch Aufbringen verschiedener Leuchtpigmente komplexe Farbmuster verwirklicht werden. Auf diese Art kann in vorteilhafter Weise jede gewünschte Form und jedes Motiv aufgebracht werden.

Ein bevorzugtes Beispiel für die Basis eines solchen Leuchtpigmentes ist Zinksulfid. Bevorzugt zur Ausbildung der lichtemittierenden Schicht verwendbar ist Zinksulfid, das mit Metallen wie Kupfer oder Mangan dotiert ist. Die Leuchtpigmente können mit einer transparenten Schicht umhüllt sein. Dies kann in vorteilhafter Weise die Leuchtpigmente vor eintretender Feuchtigkeit schützen. Eine entsprechende lichtemittierende Paste ist beispielsweise unter der Bezeichnung Ormecon® EL 5400 bei der Firma Ormecon erhältlich.

Ein besonders gutes Leuchtergebnis, insbesondere ein flächiges Leuchten, kann erzeugt werden, wenn die lichtemittierende Schicht möglichst dünn aufgetragen wird. In bevorzugten Ausführungsformen bringt man die lichtemittierende Schicht mit einer Schichtdicke im Bereich von ≥ 2 µm bis ≤ 20 µm, vorzugsweise im Bereich von ≥ 5 µm bis ≤ 15 µm, bevorzugt im Bereich von ≥ 8 µm bis ≤ 12 µm, auf.

Gemäß einem bevorzugten Verfahren bringt man auf die lichtemittierende Schicht in einem nächsten Schritt wenigstens eine dielektrische Schicht auf. Vorzugsweise überdeckt die dielektrische Schicht die Leuchtschicht um mindestens 5 mm an jeder Seite und lässt dabei einen ausreichenden Bereich von mindestens 1,5 cm der Frontelektrode frei. Die dielektrische Schicht enthält vorzugsweise ein Material mit einer hohen Dielektrizitätskonstante, beispielsweise Bariumtitanat. Dieses ist vorzugsweise in einem polymeren Bindemittel verteilt, wodurch eine druckfähige Paste zur Verfügung gestellt werden kann. Eine geeignete dielektrische Paste ist beispielsweise unter der Bezeichnung Ormecon® EL 5500 bei der Firma Ormecon erhältlich.

Üblicher Weise wird wenigstens eine dielektrische Schicht aufgetragen. Vorzugsweise werden wenigstens zwei oder mehrere dielektrische Schichten aufgetragen. Dies kann zu einer Erhöhung der isolierenden Eigenschaften führen, wodurch die Gefahr eines Kontaktes zwischen den leitenden Schichten der Schichtanordnung verringert wird. Die dielektrische Schicht deckt vorzugsweise die gesamte Oberfläche der lichtemittierenden Schicht ab. Bevorzugt deckt die dielektrische Schicht jedoch nicht die gesamte Fläche der Frontelektrode ab. Dies stellt eine zumindest geringe Fläche der Frontelektrode zur späteren Kontaktierung zur Spannungsquelle zur Verfügung.

Eine gute Isolierung in Verbindung mit einer guten Flexibilität des elektrolumineszierenden Textils konnte erzeugt werden, wenn man die wenigstens eine dielektrische Schicht(en) mit einer Gesamtschichtdicke im Bereich von ≥ 10 µm bis ≤ 50 µm aufträgt. In bevorzugten Ausführungsformen bringt man die wenigstens eine dielektrische Schicht(en) mit einer Gesamtschichtdicke im Bereich von ≥ 10 µm bis ≤ 50 µm, vorzugsweise im Bereich von ≥ 15 µm bis ≤ 40 µm, bevorzugt im Bereich von ≥ 20 µm bis ≤ 30 µm, auf. Vorzugsweise weist eine dielektrische Schicht eine Schichtdicke im Bereich von ≥ 5 µm bis ≤ 50 µm, vorzugsweise im Bereich von ≥ 8 µm bis ≤ 40 µm, bevorzugt im Bereich von ≥ 15 µm bis ≤ 30 µm, auf.

Im Sinne der vorliegenden Erfindung kann die Reihenfolge der Auftragung der lichtemittierenden Schicht und der dielektrischen Schicht variieren. Beispielsweise kann in einer Ausführungsform, wobei die erste Oberfläche des Textilsubstrats die Rückseite ausbildet, die lichtemittierende Schicht vor der dielektrischen Schicht aufgetragen werden, während in einer Ausführungsform wobei die erste Oberfläche des Textilsubstrats die Vorderseite ausbildet, die dielektrische Schicht vor der lichtemittierenden Schicht aufgetragen wird.

Gemäß einem alternativen Verfahren, das nicht zur Erfindung gehört, wird ein Verfahren zur Herstellung eines elektrolumineszierenden Textils zur Verfügung gestellt umfassend die nachfolgenden Schritte:
a) Bereitstellen eines Textilsubstrats;
b) optional Aufbringen einer Schutzschicht auf eine erste Oberfläche des Textilsubstrats;
c) Aufbringen einer leitfähigen Schicht auf die erste Oberfläche des Textilsubstrats oder die Schutzschicht;
d) Aufbringen wenigstens einer dielektrischen Schicht auf die leitfähige Schicht;
e) Aufbringen wenigstens einer lichtemittierenden Schicht auf die dielektrische Schicht;
f) Aufbringen wenigstens einer transparenten leitfähigen Schicht auf die lichtemittierende Schicht;
g) optional Anbringen von Anschlusselementen an den leitfähigen Schichten;
h) Aufbringen einer Deckschicht auf die elektrolumineszierende Schichtanordnung; und
i) elektrisches Verbinden der transparenten leitfähigen Schicht und der leitfähigen Schicht mit einer Spannungsquelle.

Wenn die erste Oberfläche des Textilsubstrats die spätere Vorderseite ausbildet, kann es entsprechend alternativ vorgesehen sein, die Reihenfolge der Auftragung der Schichten der elektrolumineszierenden Schichtanordnung umzukehren. In diesem Verfahren wird auf die erste Oberfläche des Textilsubstrats zunächst die auch Rückelektrode genannte leitfähige Schicht aufgetragen, auf diese dann die dielektrische Schicht, anschließend auf die dielektrische Schicht die lichtemittierende Schicht, und danach die transparente, auch Frontelektrode genannte, leitfähige Schicht. Der Lichtweg geht in der entsprechend hergestellten Anordnung nicht durch das Textil. Insofern ist es bevorzugt, eine nicht transparente leitfähigen Schicht auf die erste Oberfläche des Textilsubstrats oder die Schutzschicht aufzutragen.

Der Begriff "erste" transparente leitfähige Schicht wird, wenn nicht abweichend angegeben, in der vorliegenden Erfindung in Bezug auf die Frontelektrode verwendet, während der Begriff "zweite" leitfähige Schicht in Bezug auf die Rückelektrode verwendet wird. Entsprechend trägt man gemäß dem vorstehend beschriebenen alternativen Verfahren zunächst die "zweite" leitfähige Schicht oder Rückelektrode und anschließend erst die "erste" transparente leitfähige Schicht oder Frontelektrode auf.

Gemäß einem bevorzugten Verfahren bringt man vorzugsweise mittig auf die dielektrische Schicht in einem nächsten Schritt wenigstens eine zweite leitfähige Schicht auf. Bevorzugt übertritt die zweite leitfähige Schicht mit einem Abstand von mindestens 5 mm den Bereich des Dielektrikum nicht. Vorzugsweise wird diese Schicht passgenau über die lichtemittierende Schicht aufgebracht. Die zweite leitfähige Schicht kann eine transparente oder nicht transparente Schicht sein und wird auch Rückelektrode genannt.

Verwendbar zur Ausbildung der leitfähigen Schicht sind beispielsweise leitfähige Polymere, vorzugsweise ausgewählt aus der Gruppe umfassend Polyanilin, Polypyrrol und/oder Polyethylen-Dioxithiophen (PEDT). Weiter verwendbar zur Ausbildung der leitfähigen Schicht sind leitfähige Materialien, vorzugsweise Silber oder Kohlenstoffpartikel, die in einem Polymer enthalten sind. Vorzugsweise verwendbar ist eine leitfähige Paste enthaltend Silber, insbesondere bevorzugt verwendbar ist eine Paste enthaltend Silber und Polyanilin. Weiter kann die leitfähige Schicht aus transparenten leitfähigen Materialien wie Indium-Zinnoxid ausgebildet werden. Eine geeignete leitfähige Paste ist beispielsweise unter der Bezeichnung Ormecon® EL 5800 bei der Firma Ormecon erhältlich.

Eine gute Leitfähigkeit in Verbindung mit einer guten Flexibilität des elektrolumineszierenden Textils konnte erzeugt werden, wenn man wenigstens eine zweite leitfähige Schicht(en) mit einer Gesamtschichtdicke im Bereich von ≥ 10 µm bis ≤ 80 µm aufträgt. In bevorzugten Ausführungsformen bringt man die wenigstens eine zweite leitfähige Schicht(en) mit einer Gesamtschichtdicke im Bereich von ≥ 10 µm bis ≤ 80 µm, vorzugsweise im Bereich von ≥ 15 µm bis ≤ 50 µm, bevorzugt im Bereich von ≥ 20 µm bis ≤ 40 µm, auf. Vorzugsweise weist eine zweite leitfähige Schicht eine Schichtdicke im Bereich von ≥ 5 µm bis ≤ 80 µm, vorzugsweise im Bereich von ≥ 15 µm bis ≤ 40 µm, bevorzugt im Bereich von ≥ 20 µm bis ≤ 30 µm, auf. Die zweite leitfähige Schicht auf der dielektrischen Schicht berührt die erste leitfähige Schicht (Frontelektrode) nicht. Dies ermöglicht bei Anschluss an eine Spannungsquelle den Stromfluss durch alle Schichten und vermeidet einen Kurzschluss.

Durch die Abstimmung der Schichtdicken kann eine gute Elektrolumineszenz und zugleich eine gute Flexibilität des Textils zur Verfügung gestellt werden. Von besonderem Vorteil ist hierbei, dass die textilübliche Haptik beibehalten werden kann.

In einer bevorzugten Ausführungsform umfasst das erfindungsgemäße Verfahren, dass man
- eine erste transparente leitfähige Schicht mit einer Schichtdicke im Bereich von ≥ 2 µm bis ≤ 15 µm, vorzugsweise im Bereich von ≥ 5 µm bis ≤ 12 µm, bevorzugt im Bereich von ≥ 8 µm bis ≤ 10 µm, und/oder
- wenigstens eine lichtemittierende Schicht(en) mit einer Gesamtschichtdicke im Bereich von ≥ 2 µm bis ≤ 20 µm, vorzugsweise im Bereich von ≥ 5 µm bis ≤ 15 µm, bevorzugt im Bereich von ≥ 8 µm bis ≤ 12 µm, und/oder
- wenigstens eine dielektrische Schicht(en) mit einer Gesamtschichtdicke im Bereich von ≥ 10 µm bis ≤ 50 µm, vorzugsweise im Bereich von ≥ 15 µm bis ≤ 40 µm, bevorzugt im Bereich von ≥ 20 µm bis ≤ 30 µm, und/oder
- wenigstens eine zweite leitfähige Schicht(en) mit einer Gesamtschichtdicke im Bereich von ≥ 10 µm bis ≤ 80 µm, vorzugsweise im Bereich von ≥ 15 µm bis ≤ 50 µm, bevorzugt im Bereich von ≥ 20 µm bis ≤ 40 µm,
aufbringt.

Erfindungsgemäß werden die Schichtdicken der einzelnen Schichten der elektrolumineszierenden Schichtanordnung derart gewählt, dass eine gute Elektrolumineszenz zur Verfügung gestellt werden kann, und zugleich die Flexibilität des Textils erhalten bleibt. Die Gesamtschichtdicke der elektrolumineszierenden Schichtanordnung ist vorzugsweise dünner als die Dicke des Textilsubstrats. Dies trägt maßgeblich zu dem Erhalt der textilen Haptik des hergestellten elektrolumineszierenden Textils bei.

In einer bevorzugten Ausführungsform umfasst das erfindungsgemäße Verfahren, dass man auf ein Textilsubstrat eine elektrolumineszierende Schichtanordnung mit einer Gesamtschichtdicke der elektrolumineszierenden Schichtanordnung im Bereich von ≥ 0,1 mm bis ≤ 1 mm, vorzugsweise im Bereich von ≥ 0,15 mm bis ≤ 0,5 mm, bevorzugt im Bereich von ≥ 0,18 mm bis ≤ 0,3 mm, besonders bevorzugt im Bereich von ≥ 0,19 mm bis ≤ 0,2 mm, aufbringt.

Eine Gesamtschichtdicke der elektrolumineszierenden Schichtanordnung kleiner 1 mm ist bereits wesentlich geringer als bei üblichen bekannten elektrolumineszierenden Textilien. Eine besonders gute Flexibilität der erfindungsgemäß hergestellten elektrolumineszierenden Textilien kann bei Gesamtschichtdicken der elektrolumineszierenden Schichtanordnung im Bereich von ≥ 0,15 mm bis ≤ 0,5 mm, bevorzugt im Bereich von ≥ 0,18 mm bis ≤ 0,3 mm, zur Verfügung gestellt werden. Insbesondere bei Gesamtschichtdicken der elektrolumineszierenden Schichtanordnung im Bereich von ≥ 0,19 mm bis ≤ 0,2 mm kann der gesamte Schichtaufbau der elektrolumineszierenden Schichtanordnung dünner als ein dünnes Trägertextil sein. Dies führt dazu, dass das hergestellte elektrolumineszierende Textil seine textile Haptik beibehält. Damit kann in vorteilhafter Weise der textile Charakter des elektrolumineszierenden Textils insgesamt erhalten werden.

Von Vorteil ist weiterhin, dass ein solch dünnes elektrolumineszierendes Textil, in Abhängigkeit vom Verhalten des textilen Trägers, einen Biegeradius im Bereich von ≥ 1 cm bis ≤ 2 cm aufweisen kann. Dies ermöglicht, das elektrolumineszierende Textil für diverse Einsatzmöglichkeiten zu verwenden.

Ein Fixieren der jeweiligen Schichten kann durch Trocknungsschritte nach dem jeweiligen Aufbringen erzielt werden. Die aufgebrachte Paste wird vorzugsweise durch jeweils anschließende Trocknungsvorgänge getrocknet und fixiert. Hierdurch kann sich eine verfestigte Schicht ausbilden, auf die weitere pastöse Schichten aufgebracht werden können. Von Vorteil ist, dass durch Verwendung der Pasten und Trocknen der einzelnen Schichten kein Entwässern, zusätzliches Trocknen oder Thermofixieren notwendig wird.

Es konnte festgestellt werden, dass Trocknungsschritte bei 90°C bis 130°C für ein bis fünf Minuten für eine ausreichende Trocknung der Schichten ausreichen. Vorzugsweise führt man das Trocknen bei Temperaturen im Bereich von ≥ 70°C bis ≤ 130°C, vorzugsweise im Bereich von ≥ 80°C bis ≤ 120°C, bevorzugt im Bereich von ≥ 90°C bis ≤ 95°C, durch. Bevorzugt führt man das Trocknen in einem Zeitraum von ≤ 0,5 Minuten bis ≤ 10 Minuten, vorzugsweise in einem Zeitraum von ≤ 1 Minute bis ≤ 5 Minuten durch. In vorteilhafter Weise reduziert ein Trocken, insbesondere der Leucht-, der dielektrischen und der zweiten leitfähigen Schicht, im Bereich von ≥ 90°C bis ≤ 95°C die Bildung von Rissen und/oder Bläschen in den Schichten. Dies führt zu einer weiteren Verbesserung der Elektrolumineszenz durch die einzelnen Schichten.

Das erfindungsgemäße Verfahren umfasst das Aufbringen einer leitfähigen Schiene auf die erste transparente leitfähige Schicht. Es ist vorteilhaft eine leitfähige Schiene, eine so genannte Bus-bar, an den Seiten, insbesondere am Rand der elektrolumineszierenden Fläche aufzubringen. Dies kann in vorteilhafter Weise eine gleichmäßige Lumineszenz größerer Flächen gewährleisten. Diese leitfähige Schiene ist umlaufend aufgebracht. Bevorzugt läuft die leitfähige Schiene vollständig um die dielektrische Schicht herum und liegt auf der transparenten leitfähigen Schicht auf. Die leitfähige Schiene kann die Funktion einer zusätzlichen Randelektrode zur Unterstützung der transparenten ersten Elektrodenschicht und zur gleichmäßigen Verteilung der Spannung aufweisen.

Die leitfähige Schiene ist aus dem Material der zweiten leitfähigen Schicht ausgebildet. Vorzugsweise wird die leitfähige Schiene in einem gemeinsamen Schritt mit der zweiten leitfähigen Schicht ausgebildet. Vorzugsweise kontaktiert die leitfähige Schiene die zweite leitfähige Schicht wie auch das Dielektrikum jedoch nicht. Dies vermeidet einen Kurzschluss in der elektrolumineszierenden Schichtanordnung.

Vorzugsweise trägt man eine leitfähige Schiene oder Bus-bar mit einer Gesamtschichtdicke im Bereich von ≥ 10 µm bis ≤ 80 µm, vorzugsweise im Bereich von ≥ 20 µm bis ≤ 50 µm, bevorzugt im Bereich von ≥ 30 µm bis ≤ 40 µm, auf.

Für die Funktionsfähigkeit der elektrolumineszierenden Schichtanordnung ist eine Isolation der leitfähigen Schichten durch das Dielektrikum notwendig. Diese Funktionsfähigkeit kann durch die Gestaltung und/oder Geometrie der einzelnen Schichten während des Aufbringens sichergestellt werden. Insbesondere ist es vorteilhaft, wenn die einzelnen Schichten möglichst genau insbesondere
mit definiertem Abstand zueinander übereinander liegen. Dies ermöglicht ein Zusammenwirken der Schichten zur Herstellung der Elektrolumineszenz und ein Vermeiden von Fehlerquellen.

Hierbei ist insbesondere bei Verwendung von Drucktechniken das Verwenden von Druckschablonen hilfreich. Bei Verwendung von Beschichtungstechniken ist ein exaktes Zusammenspiel der Abmessungen der einzelnen Flächen hilfreich.

Vorzugsweise wird die lichtemittierende Schicht mittig auf der ersten transparenten leitfähigen Schicht oder Frontelektrode aufgebracht. Die dielektrische Schicht überdeckt die lichtemittierende Schicht möglichst vollständig, wobei sie vorzugsweise etwas über den Rand hinausgeht. Hierbei werden vorzugsweise die Randbereiche der ersten leitfähigen Schicht oder Frontelektrode nicht abgedeckt, damit diese mit einer Spannungsquelle kontaktiert werden können. Die zweite leitfähige Schicht oder Rückelektrode berührt die erste leitfähige Schicht oder Frontelektrode nicht, um Kurzschlüsse zu vermeiden.

In einem weiteren optionalen Schritt bringt man Anschlusselemente an den leitfähigen Schichten an. Die Anschlusselemente können zur elektrischen Verbindung der leitfähigen Schichten mit einer Spannungsquelle dienen. Die Anschlusselemente vereinfachen in vorteilhafter Weise das elektrische Verbinden der leitfähigen Schichten mit der Spannungsquelle.

Vorzugsweise bringt man auf die Seitenränder der transparenten leitfähigen Schicht insbesondere auf die leitfähige Schiene und die zweite leitfähige Schicht, die Rückelektrode, ein zusätzliches Anschlusselement, beispielsweise eine Metallfolie, insbesondere eine Kupferfolie, auf die vorzugsweise jeweils ein Kabel aufgelötet ist, auf. Beispielsweise kann ein solches Anschlusselement aufgeklebt werden. In vorteilhafter Weise kann das Anschlusselement beispielsweise eine Kupferfolie, vorzugsweise mit Kabel, zu einer einfacheren Handhabung und/oder gleichmäßigeren Verteilung der Spannung beitragen. Weiter kann ein auf ein Anschlusselement gelötetes Kabel in vorteilhafter Weise das elektrische Verbinden der leitfähigen Schichten über die Anschlusselemente mit einer Spannungsquelle erleichtern.

In einem weiteren Schritt bringt man eine Deckschicht auf die elektrolumineszierende Schichtanordnung auf. Die Deckschicht kann mehrere Vorteile zur Verfügung stellen, beispielsweise eine elektrische Isolation der elektrolumineszierende Schichtanordnung. Hierdurch kann die Gefahr eines Kurzschlusses durch Kontakt der Schichten beispielsweise bei der Handhabung des elektroluminszierenden Textils verringert werden. Weiterhin kann auch die Gefahr eines elektrischen Schlages für eine Person, die das Textil berührt, verringert werden. Weiterhin kann eine Deckschicht die beschichteten Flächen des Textils von anderen beschichteten oder unbeschichteten Flächen isolieren.

Die Deckschicht ist vorzugsweise eine transparente und/oder elastische Deckschicht. Vorzugsweise weise die Deckschicht elektrisch isolierende Eigenschaften auf. Bevorzugt verwendbar sind isolierende Materialien ausgewählt aus der Gruppe Polyurethane, Acrylat, Polyvinylchlorid und/oder Polytetrafluorethylen (PTFE). Weiter bevorzugt ist das Ausbilden einer Deckschicht durch Aufbringen eines nicht-leitfähigen Polymers, bevorzugt Polyurethan mit einem Zusatz von Keramik oder Silikon. Die Deckschicht ist bevorzugt durch Laminieren oder Beschichten aufbringbar. Beispielsweise kann die elektrolumineszente Schichtanordnung mit einer Folie des isolierenden Materials laminiert werden, wodurch ein Schutz-Laminat auf das elektrolumineszierende Textil aufgebracht werden kann. Von besonderem Vorteil ist hierbei, dass die elektrolumineszierende Schichtanordnung vorzugsweise auf der Rückseite des elektrolumineszierenden Textils aufgebracht ist, und eine solche Deckschicht oder Schutz-Laminat die elektrolumineszierenden Eigenschaft des Textils nicht beeinträchtigt. Weiterhin wird durch eine hintere Deckschicht oder Schutz-Laminat die textile Haptik der Textiloberfläche nicht beeinträchtigt. Die Deckschicht schützt Personen bei der Handhabung. Weiterhin schützt die Deckschicht auch das Textil selbst, beispielsweise gegen den Einfluss von Feuchtigkeit, Schmutz, UV-Strahlen und Ähnlichem. Weiterhin wird durch Zusatz von lichtabsorbierenden Materialien in dieser Schicht ein Blackout-Effekt ermöglicht.

Die Deckschicht kann in weiteren Ausführungsformen, vorzugsweise wenn die Deckschicht die dem Betrachter zugewandte Seite des elektrolumineszierenden Textils ist, ebenfalls ein Motiv und/oder eine Färbung aufgebracht sein. Ein solches Motiv kann beispielsweise durch Foliendruck aufgebracht werden.

Die elektrolumineszierende Schichtanordnung kann durch Wechselspannung zum Leuchten angeregt werden. In einem weiteren Schritt erfolgt daher ein elektrisches Verbinden der ersten transparenten leitfähigen Schicht und der zweiten leitfähigen Schicht mit einer Spannungsquelle, vorzugsweise über die Anschlusselemente. Ein elektrisches Anschließen der transparenten leitfähigen Schicht erfolgt an die positive oder negative Polarität, während die zweite leitfähige Schicht an die jeweils andere Polarität angeschlossen wird.

Bevorzugt ist die Spannungsquelle eine Wechselspannungsquelle. Es kann selbstverständlich auch eine Stromquelle verwendet werden. Das elektrolumineszierende Textil kann auch an eine Gleichspannungsquelle beispielsweise eine Hausstromquelle angeschlossen werden, wenn ein Inverter oder Spannungswandler die Gleichspannung in die notwendige Wechselspannung umwandelt. Vorzugsweise wird daher das elektrolumineszierende Textil über einen Inverter an eine Gleichspannungsquelle angeschlossen. In vorteilhafter Weise kann eine transportable Spannungsquelle beispielsweise eine Batterie die Spannungsquelle darstellen. Vorzugsweise ist die transportable Spannungsquelle beispielsweise eine Batterie sowie ein gegebenenfalls notwendiger Inverter, der die Spannung der transportablen Spannungsquelle in Wechselspannung umwandelt, in das textile Substrat integriert. Dies ermöglicht, dass das elektrolumineszierende Textil beispielsweise als Kleidungsstück ausgebildet sein kann.

Ein weiterer Gegenstand der Erfindung betrifft ein elektrolumineszierendes Textil hergestellt nach dem erfindungsgemäßen Verfahren.

Das elektrolumineszierende Textil hergestellt nach dem erfindungsgemäßen Verfahren umfasst vorzugsweise die folgenden Schichten:
- ein Textilsubstrat;
- optional eine Schutzschicht auf einer ersten Oberfläche des Textilsubstrats;
- eine erste transparente leitfähige Schicht auf der ersten Oberfläche des Textilsubstrats oder der Schutzschicht;
- wenigstens eine lichtemittierende Schicht;
- wenigstens eine dielektrische Schicht;
- wenigstens eine zweite leitfähige transparente oder nicht transparente Schicht;
- optional elektrische Anschlusselemente an den leitfähigen Schichten;
- eine Deckschicht.

Ein weiterer Gegenstand der Erfindung betrifft ein elektrolumineszierendes Textil umfassend:
- ein Textilsubstrat;
- optional eine Schutzschicht auf einer ersten Oberfläche des Textilsubstrats;
- eine erste transparente leitfähige Schicht auf der ersten Oberfläche des Textilsubstrats oder der Schutzschicht;
- wenigstens eine lichtemittierende Schicht;
- wenigstens eine dielektrische Schicht;
- wenigstens eine zweite leitfähige transparente oder nicht transparente Schicht;
- optional elektrische Anschlusselemente an den leitfähigen Schichten;
- eine Deckschicht.

Zur Beschreibung des Textilsubstrats, der Schichten und Anschlusselemente wird auf die vorstehende Beschreibung Bezug genommen.

Ein bedeutender Vorteil der insbesondere erfindungsgemäß herstellbaren elektrolumineszierenden Textilien liegt darin, dass das Textil und die elektrolumineszierende Schichtanordnung fest und nicht lösbar miteinander verbunden sind. In vorteilhafter Weise weisen die insbesondere erfindungsgemäß herstellbaren elektrolumineszierenden Textilien keine Haftvermittlerschicht auf. Es liegt somit in vorteilhafter Weise ein einteiliges elektrolumineszierendes Textil vor. Dies kann Störungen des Leuchteffektes durch einen gestörten Zusammenhalt des Textilsubstrats und der elektrolumineszierenden Schichtanordnung vermeiden, wie sie durch Fehler beim Aufbringen einer Haftvermittlerschicht oder einer Alterung des Haftvermittlers auftreten können. Weiterhin hat ein einteiliges elektrolumineszierendes Textil den großen Vorteil, dass die elektrolumineszierende Schichtanordnung nicht Gefahr läuft, von dem Textil abgetrennt zu werden, wie dies beispielsweise bei einer aufgeklebten Anordnung leicht passieren kann. Ferner wird die Flexibilität der erfindungsgemäß hergestellten elektrolumineszierenden Textilien nicht durch eine Haftvermittlerschicht verringert.

In einer bevorzugten Ausführungsform umfasst das Textilsubstrat des elektrolumineszierenden Textils, insbesondere hergestellt nach dem erfindungsgemäßen Verfahren, einen Motivdruck auf einer zweiten Oberfläche. Die zweite Oberfläche des Textilsubstrats ist vorzugsweise die Vorderseite des elektrolumineszierenden Textils. Der Motivdruck kann durch Färben oder Drucken, insbesondere Pigmentdruck, erfolgen. Insbesondere kann das elektrolumineszierende Textil mehrere verschiedenfarbige Drucke aufweisen. Durch Mehrfarbendruck kann das elektrolumineszierende Textil farbige oder mehrfarbige leuchtende Motive aufweisen.

In weiter bevorzugten Ausführungsformen des elektrolumineszierenden Textils, insbesondere hergestellt nach dem erfindungsgemäßen Verfahren, weist:
- die erste transparente leitfähige Schicht eine Schichtdicke im Bereich von ≥ 2 µm bis ≤ 15 µm, vorzugsweise im Bereich von ≥ 5 µm bis ≤ 12 µm, bevorzugt im Bereich von ≥ 8 µm bis ≤ 10 µm; und/oder
- die wenigstens eine lichtemittierende Schicht(en) eine Gesamtschichtdicke im Bereich von ≥ 2 µm bis ≤ 20 µm, vorzugsweise im Bereich von ≥ 5 µm bis ≤ 15 µm, bevorzugt im Bereich von ≥ 8 µm bis ≤ 12 µm; und/oder
- die wenigstens eine dielektrische Schicht(en) eine Gesamtschichtdicke im Bereich von ≥ 10 µm bis ≤ 50 µm, vorzugsweise im Bereich von ≥ 15 µm bis ≤ 40 µm, bevorzugt im Bereich von ≥ 20 µm bis ≤ 30 µm, und/oder
- die wenigstens eine zweite leitfähige Schicht(en) eine Gesamtschichtdicke im Bereich von ≥ 10 µm bis ≤ 80 µm, vorzugsweise im Bereich von ≥ 15 µm bis ≤ 50 µm, bevorzugt im Bereich von ≥ 20 µm bis ≤ 40 µm, auf.

In vorteilhafter Weise können textile Eigenschaften des Textilsubstrats erhalten bleiben. Dies bedeutet einen großen Vorteil gegenüber einer Folienbeschichtung, bei der die Folien auf dem Textil aufgebracht wird, wodurch die textile Struktur bedeckt wird.

Die Gesamtschichtdicke der elektrolumineszierenden Schichtanordnung ist vorzugsweise dünner als die Dicke des Textilsubstrats. Dies trägt maßgeblich zu dem Erhalt der textilen Haptik des elektrolumineszierenden Textils bei. Von Vorteil ist hierbei insbesondere, dass eine gute Elektrolumineszenz zur Verfügung gestellt werden kann, und zugleich die Flexibilität des Textils erhalten bleibt.

In einer bevorzugten Ausführungsform liegt die Gesamtschichtdicke der elektrolumineszierenden Schichtanordnung im Bereich von ≥ 0,1 mm bis ≤ 1 mm, vorzugsweise im Bereich von ≥ 0,15 mm bis ≤ 0,5 mm, bevorzugt im Bereich von ≥ 0,18 mm bis ≤ 0,3 mm, besonders bevorzugt im Bereich von ≥ 0,19 mm bis ≤ 0,2 mm.

Eine Gesamtschichtdicke der elektrolumineszierenden Schichtanordnung kleiner 1 mm ist bereits wesentlich geringer als bei üblichen bekannten elektrolumineszierenden Textilien. Eine besonders gute Flexibilität der erfindungsgemäßen elektrolumineszierenden Textilien kann bei Gesamtschichtdicken der elektrolumineszierenden Schichtanordnung im Bereich von ≥ 0,15 mm bis ≤ 0,5 mm, bevorzugt im Bereich von ≥ 0,18 mm bis ≤ 0,3 mm, zur Verfügung gestellt werden. Insbesondere bei Gesamtschichtdicken der elektrolumineszierenden Schichtanordnung im Bereich von ≥ 0,19 mm bis ≤ 0,2 mm kann der gesamte Schichtaufbau der elektrolumineszierenden Schichtanordnung dünner als ein dünnes Trägertextil sein. Dies führt dazu, dass hergestellte elektrolumineszierende Textil seine textile Haptik beibehält. Damit kann in vorteilhafter Weise der textile Charakter des elektrolumineszierenden Textils insgesamt erhalten werden.

Von Vorteil ist weiterhin, dass ein solch dünnes elektrolumineszierendes Textil, in Abhängigkeit vom Verhalten des textilen Trägers, einen Biegeradius im Bereich von ≥ 1 cm bis ≤ 2 cm aufweisen kann. Dies ermöglicht, das elektrolumineszierende Textil für diverse Einsatzmöglichkeiten zu verwenden.

Geeignete textile Substrate sind beispielsweise ausgewählt aus der Gruppe umfassend Gewebe, Vlies, Gewirke oder einer Kombination hiervon. Geeignete Textilmaterialien sind beispielsweise Pflanzenfasern, Fasern tierischen Ursprungs, Mineralfasern geologischen Ursprungs, Chemiefasern, Fasern aus synthetischen Polymeren, anorganischen Chemiefasern oder Kunstleder. Geeignete Textilmaterialien sind bevorzugt Baumwolle, Seide, Leinen und/oder Synthesefasern beispielsweise ausgewählt aus der Gruppe umfassend Polyamid, Polyacryl, Elasthan, Polyester und/oder Polyethylen. Diese Materialien sind im Sinne der Erfindung bevorzugt unter dem Begriff "Textil" zu verstehen.

Hierbei sind dichtere und/oder festere textile Substrate vorteilig. Besonders bevorzugt ist ein sehr dichtes Gewebe aus Polyester. In vorteilhafter Weise können auf diese die Pasten sehr gut aufgetragen werden.

Vorzugsweise Textilien, die durchlässiger, weniger dicht gewebt oder aufnahmefähiger sind, können optional eine Schutzschicht auf einer ersten Oberfläche des Textilsubstrats aufweisen. Die erste Oberfläche des Textilsubstrats ist vorzugsweise die Rückseite, des Textils. In anderen Ausführungsformen kann die erste Oberfläche des Textilsubstrats die Vorderseite des Textils sein. In dieser Ausführungsform befindet sich die elektrolumineszierende Schichtanordnung auf der Vorderseite des Textils.

Eine solche Schutzschicht kann in vorteilhafter Weise als Schutz insbesondere vor dem unerwünschten Durchtränken des Gewebes mit der aufzutragenden Schicht dienen. In vorteilhafter Weise ist eine solche Schutzschicht kaum oder nicht fühlbar und erhält die textile Eigenschaft. Die Schichtdicke der Schutzschicht liegt vorzugsweise im Bereich von ≥ 0,5 µm bis ≤ 10 µm, vorzugsweise im Bereich von ≥ 1 µm bis ≤ 5 µm.

Es kann weiter vorgesehen sein, dass das Textilsubstrat eine weitere Schutzschicht auf der zweiten Oberfläche des Textilsubstrats aufweist. Die zweite Oberfläche des Textilsubstrats ist vorzugsweise die spätere Vorderseite, des Textils. Eine solche Beschichtung kann einen Schutz vor äußeren Einflüssen, insbesondere einem Schutz gegen Wasser oder Trockenschmutz aus der Atmosphäre zur Verfügung stellen. Die Schichtdicke einer äußeren Schutzschicht liegt vorzugsweise im Bereich von ≥ 0,5 µm bis ≤ 10 µm, vorzugsweise im Bereich von ≥ 1 µm bis ≤ 5 µm.

Bevorzugte Materialien der Schutzschicht sind Polymere ausgewählt aus der Gruppe umfassend Silikone, Polyurethane, Polyvinylchlorid, Polysulfide und/oder Acrylate, bevorzugt ausgewählt aus der Gruppe umfassend Silikone und/oder Polyurethane. In besonders bevorzugten Ausführungsformen umfasst eine Schutzschicht auf der ersten Oberfläche, vorzugsweise der späteren Rückseite, des Textilsubstrats ein Polyurethans. Weiter bevorzugt umfasst eine Schutzschicht auf der zweiten Oberfläche, vorzugsweise der späteren Vorderseite, des Textilsubstrats ein Silikon.

Bevorzugt verwendbar als erste transparente leitfähige Schicht sind leitfähige transparente Polymere, vorzugsweise Polyethylen-Dioxithiophen (PEDT). Weiter kann die leitfähige Schicht aus transparenten leitfähigen Materialien wie Indium-Zinnoxid ausgebildet sein. Die transparente leitfähige Schicht kann weiter aus einem Polyesterfilm, welcher mit Indium-Zinnoxid (ITO, Indium Tin Oxide) oder einem anderen leitfähigen Polymer beschichtet ist, ausgebildet sein. Indium-Zinnoxid ist elektrisch leitfähig, sowie transparent und kann in vorteilhafter Weise eine hohe Lichttransmission der elektrolumineszierenden Schichtanordnung unterstützen. Bevorzugt ist eine transparente leitfähige Schicht umfassend Polyethylen-Dioxithiophen auf Basis eines synthetischen Polymers. In bevorzugten Ausführungsformen weist die erste transparente leitfähige Schicht eine Schichtdicke im Bereich von ≥ 2 µm bis ≤ 15 µm, vorzugsweise im Bereich von ≥ 5 µm bis ≤ 12 µm, bevorzugt im Bereich von ≥ 8 µm bis ≤ 10 µm, auf. Weiter weist die transparente leitfähige Schicht oder Frontelektrode vorzugsweise eine Flächenabdeckung im Bereich von ≥ 300 cm²/g bis ≤ 400 cm²/g, bevorzugt von ≥ 350 cm²/g auf.

Bevorzugt umfasst die wenigstens eine lichtemittierende Schicht organische lichtemittierende Polymere oder anorganische lichtemittierende Materialien, bevorzugt anorganische lichtemittierende Materialien. Die lichtemittierende Schicht umfasst in bevorzugten Ausführungsformen Leuchtpigmente, die in einem organischen oder keramischen Bindemittel eingebettet sind. Bevorzugte Leuchtpigmente sind Phosphore auf Basis von anorganischem SiC und/oder ZnS, die mit Metallen vorzugsweise ausgewählt aus der Gruppe umfassend Cu, Mn, Ag, Au, Pb, P, As, Sb, Sn, V, Tl, Sc, Cr und/oder seltene Erden dotiert sind. Diese Dotierung von ZnS oder SiC mit Fremdatomen kann zu unterschiedlichen Farberscheinungen führen. Insbesondere können der Farbton bzw. die Wellenlängenbereiche des emittierten Lichtes, durch das Dotierungselement bestimmt werden. Ein bevorzugtes Beispiel für die Basis eines solchen Leuchtpigmentes ist Zinksulfid. Bevorzugt ist Zinksulfid, das mit Metallen wie Kupfer oder Mangan dotiert ist. Ein besonders gutes Leuchtergebnis, insbesondere ein flächiges Leuchten konnte erzeugt werden, wenn die lichtemittierende Schicht möglichst dünn ist. In bevorzugten Ausführungsformen weist die lichtemittierende Schicht eine Schichtdicke im Bereich von ≥ 2 µm bis ≤ 20 µm, vorzugsweise im Bereich von ≥ 5 µm bis ≤ 15 µm, bevorzugt im Bereich von ≥ 8 µm bis ≤ 12 µm, auf.

Die lichtemittierende Schicht kann flächig oder in Form gewünschter Motive oder Designs und/oder ein- oder mehrfarbig ausgestaltet sein. Insbesondere kann die lichtemittierende Schicht gewünschte Motive ein- oder mehrfarbig ausgestaltet aufweisen. Besonders bevorzugt ist daher ein elektrolumineszierendes Textil, das in der lichtemittierenden Schicht ein- oder mehrfarbig ausgestaltete Motive aufweist. Motive in der lichtemittierenden Schicht sind beispielsweise durch Verwendung eines oder mehrerer verschiedenfarbige Leuchtpigmente enthaltender Leuchtmittel herstellbar.

Die wenigstens eine dielektrische Schicht enthält vorzugsweise ein Material mit einer hohen Dielektrizitätskonstante, beispielsweise Bariumtitanat. Dieses ist vorzugsweise in einem polymeren Bindemittel verteilt. Vorzugsweise umfasst das elektrolumineszierende Textil wenigstens zwei oder mehrere dielektrische Schichten. Dies kann zu einer Erhöhung der isolierenden Eigenschaften führen, wodurch die Gefahr eines Kontaktes zwischen den leitenden Schichten der Schichtanordnung verringert wird. Die dielektrische Schicht deckt vorzugsweise wenigstens die gesamte Oberfläche der lichtemittierenden Schicht ab.

Im Sinne der vorliegenden Erfindung kann die Reihenfolge der lichtemittierenden Schicht und der dielektrischen Schicht variieren. Beispielsweise kann in einer Ausführungsform, wobei die erste Oberfläche des Textilsubstrats die Rückseite ausbildet, die lichtemittierende Schicht unter der dielektrischen Schicht näher zum Textilsubstrat liegen, während in einer Ausführungsform wobei die erste Oberfläche des Textilsubstrats die Vorderseite ausbildet, die dielektrische Schicht unter der lichtemittierenden näher zum Textilsubstrat liegen kann.

In einer bevorzugten Ausführungsform des elektrolumineszierenden Textils, insbesondere hergestellt nach dem erfindungsgemäßen Verfahren, ist entsprechend:
- wenigstens eine lichtemittierende Schicht auf der transparenten leitfähigen Schicht;
- wenigstens eine dielektrische Schicht auf der lichtemittierenden Schicht;
- wenigstens eine zweite leitfähige transparente oder nicht transparente Schicht auf der dielektrischen Schicht
angeordnet.

Eine gute Isolierung in Verbindung mit einer guten Flexibilität des elektrolumineszierenden Textils konnte erzeugt werden, wenn die wenigstens eine dielektrische Schicht(en) eine Gesamtschichtdicke im Bereich von ≥ 10 µm bis ≤ 50 µm aufweist. In bevorzugten Ausführungsformen weist die wenigstens eine dielektrische Schicht(en) eine Gesamtschichtdicke im Bereich von ≥ 10 µm bis ≤ 50 µm, vorzugsweise im Bereich von ≥ 15 µm bis ≤ 40 µm, bevorzugt im Bereich von ≥ 20 µm bis ≤ 30 µm, auf. Vorzugsweise weist eine dielektrische Schicht eine Schichtdicke im Bereich von ≥ 5 µm bis ≤ 50 µm, vorzugsweise im Bereich von ≥ 8 µm bis ≤ 40 µm, bevorzugt im Bereich von ≥ 15 µm bis ≤ 30 µm, auf.

Die wenigstens eine zweite leitfähige Schicht kann eine transparente oder nicht transparente Schicht sein. Verwendbar zur Ausbildung der leitfähigen Schicht sind beispielsweise leitfähige Polymere, vorzugsweise ausgewählt aus der Gruppe umfassend Polyanilin, Polypyrrol und/oder Polyethylen-Dioxithiophen (PEDT). Weiter verwendbar zur Ausbildung der leitfähigen Schicht sind leitfähige Materialien, vorzugsweise Silber oder Kohlenstoffpartikel, die vorzugsweise in einem Polymer enthalten sind. Vorzugsweise verwendbar ist Silber und Polyanilin. Weiter kann die leitfähige Schicht aus transparenten leitfähigen Materialien wie Indium-Zinnoxid ausgebildet werden. Eine gute Leitfähigkeit in Verbindung mit einer guten Flexibilität des elektrolumineszierenden Textils kann zur Verfügung gestellt werden, wenn die wenigstens eine zweite leitfähige Schicht(en) eine Gesamtschichtdicke im Bereich von ≥ 10 µm bis ≤ 80 µm aufweist. In bevorzugten Ausführungsformen weist die wenigstens eine zweite leitfähige Schicht(en) eine Gesamtschichtdicke im Bereich von ≥ 10 µm bis ≤ 80 µm, vorzugsweise im Bereich von ≥ 15 µm bis ≤ 50 µm, bevorzugt im Bereich von ≥ 20 µm bis ≤ 40 µm, auf. Vorzugsweise weist eine leitfähige Schicht eine Schichtdicke im Bereich von ≥ 5 µm bis ≤ 80 µm, vorzugsweise im Bereich von ≥ 15 µm bis ≤ 40 µm, bevorzugt im Bereich von ≥ 20 µm bis ≤ 30 µm, auf.

Durch die Abstimmung der Schichtdicken kann eine gute Elektrolumineszenz und zugleich eine gute Flexibilität des Textils zur Verfügung gestellt werden. Von besonderem Vorteil ist hierbei, dass die textilübliche Haptik beibehalten werden kann. Die elektrolumineszierende Schichtanordnung weist eine leitfähige Schiene auf. Die leitfähige Schiene ist auf der ersten transparenten leitfähigen Schicht angeordnet. Die elektrolumineszierende Schichtanordnung weist eine leitfähige Schiene, eine so genannte Bus-bar, umlaufend, auf. Dies kann in vorteilhafter Weise eine gleichmäßige Lumineszenz größerer Flächen gewährleisten. Bevorzugt läuft die leitfähige Schiene vollständig um die dielektrische Schicht herum und liegt auf der transparenten leitfähigen Schicht auf. Die leitfähige Schiene kann die Funktion einer zusätzlichen Randelektrode zur Unterstützung der transparenten ersten Elektrodenschicht zur gleichmäßigen Verteilung der Spannung aufweisen. Die leitfähige Schiene ist aus dem Material der zweiten leitfähigen Schicht ausgebildet. Vorzugsweise kontaktiert die leitfähige Schiene die zweite leitfähige Schicht wie auch die dielektrische Schicht jedoch nicht. Dies vermeidet einen Kurzschluss in der elektrolumineszierenden Schichtanordnung. Vorzugsweise weist die leitfähige Schiene oder Bus-bar eine Gesamtschichtdicke im Bereich von ≥ 10 µm bis ≤ 80 µm, vorzugsweise im Bereich von ≥ 20 µm bis ≤ 50 µm, bevorzugt im Bereich von ≥ 30 µm bis ≤ 40 µm, auf.

Insbesondere ist es vorteilhaft, wenn die einzelnen Schichten möglichst genau übereinander liegen. Dies ermöglicht ein Zusammenwirken der Schichten zur Herstellung der Elektrolumineszenz und ein Vermeiden von Fehlerquellen. Vorzugsweise ist die lichtemittierende Schicht mittig auf der ersten leitfähigen Schicht oder Frontelektrode aufgebracht. Die dielektrische Schicht überdeckt die lichtemittierende Schicht möglichst vollständig, wobei sie vorzugsweise etwas über den Rand hinausgeht. Hierbei sind vorzugsweise die Randbereiche der ersten leitfähigen Schicht oder Frontelektrode nicht abgedeckt, damit diese mit einer Spannungsquelle kontaktiert werden kann. Die zweite leitfähige Schicht oder Rückelektrode berührt die erste leitfähige Schicht oder Frontelektrode nicht. Hierdurch können Kurzschlüsse vermieden werden.

Optional umfasst das elektrolumineszienrende Textil elektrische Anschlusselemente an den leitfähigen Schichten. Vorzugsweise auf die Seitenränder der transparenten leitfähigen Schicht insbesondere auf die leitfähige Schiene und die zweite leitfähige Schicht, die Rückelektrode, kann ein zusätzliches Anschlusselement, beispielsweise eine Metallfolie, insbesondere eine Kupferfolie aufgebracht sein. In vorteilhafter Weise kann das Anschlusselement beispielsweise eine Kupferfolie zu einer einfacheren Handhabung und/oder gleichmäßigeren Verteilung der Spannung beitragen.

Vorzugsweise umfasst das elektrolumineszienrende Textil eine Deckschicht auf der elektrolumineszierenden Schichtanordnung, insbesondere auf der zweiten leitfähigen Schicht. Die Deckschicht kann mehrere Vorteile zur Verfügung stellen, beispielsweise eine elektrische Isolation der elektrolumineszierenden Schichtanordnung. Hierdurch kann die Gefahr eines Kurzschlusses durch Kontakt der Schichten beispielsweise bei der Handhabung des elektroluminszierenden Textils verringert werden. Weiter kann auch die Gefahr eines elektrischen Schlages für eine Person, die das Textil berührt, verringert werden. Weiterhin kann eine Deckschicht die beschichteten Flächen des Textils von anderen beschichteten oder unbeschichteten Flächen isolieren. Die Deckschicht ist vorzugsweise eine nicht-transparente und/oder elastische Deckschicht. Vorzugsweise weist die Deckschicht elektrisch isolierende Eigenschaften auf. Bevorzugt sind isolierende Materialien ausgewählt aus der Gruppe Polyurethane, Acrylat, Polyvinylchlorid und/oder Polytetrafluorethylen (PTFE). Von besonderem Vorteil ist hierbei, dass eine solche Deckschicht oder Schutz-Laminat die elektrolumineszienrende Eigenschaft des Textils nicht beeinträchtigt. Weiterhin wird durch eine hintere Deckschicht oder Schutz-Laminat die textile Haptik der Textiloberfläche nicht beeinträchtigt.

Die Deckschicht kann in weiteren Ausführungsformen, vorzugsweise wenn die Deckschicht die dem Betrachter zugewandte Seite des elektrolumineszierenden Textils ist, ebenfalls ein Motiv und/oder eine Färbung aufweisen.

Vorzugsweise weist das elektrolumineszierende Textil eine Spannungsquelle und weiter vorteilhaft einen Inverter auf, die in das textile Substrat integriert werden können. Dies ermöglicht, dass das elektrolumineszierende Textil beispielsweise als Kleidungsstück ausgebildet sein kann.

Ein weiterer Gegenstand der Erfindung betrifft die Verwendung eines erfindungsgemäßen elektrolumineszierenden Textils, insbesondere eines erfindungsgemäß hergestellten elektrolumineszierenden Textils, als Bekleidungsstück, Sicherheitstextil, Heimtextil oder als textile Leuchtfläche.

Durch die bevorzugte Ausbildung des elektrolumineszierenden Textils, insbesondere eines erfindungsgemäß hergestellten elektrolumineszierenden Textils, als gewebter oder ungewebter Kleidungsstoff, als Tapete, Teppich, Gardinen-, Fensterbehangs-, Vorhangs-, Polsterstoff, Stoff für Bezüge und/oder Verbandsmaterial ergibt sich eine Vielzahl von Anwendungsmöglichkeiten.

Elektrolumineszierende Textilien haben insbesondere eine breite Anwendungsmöglichkeit als Raumtextil, insbesondere für Beleuchtungszwecke oder zur Gestaltung von Wohn- und Arbeitsräumen, als dekoratives Textil, als Bekleidungsstück insbesondere für Sicherheitsbekleidung, oder in der Autoindustrie, beispielsweise als selbstleuchtender Dachhimmel einer Fahrgastzelle oder einem selbstleuchtenden Belag in einem Kofferraum.

Elektrolumineszierende Textilien können ferner für Polster und Bezüge Verwendung finden. Hierdurch ergeben sich zahlreiche Verwendungsmöglichkeiten in der Möbelindustrie. Besondere Effekte ergeben sich beispielsweise durch die Ausbildung als Raumtextil wie Tapeten und ähnliche Dekorationsflächen, Teppiche oder Fensterbehänge wie Gardinen und Vorhänge. Insbesondere ermöglicht die Verwendung derartiger elektrolumineszierender Textilien eine großflächige Verteilung der Lumineszenz im hiermit ausgestatteten Raum. Vor allem die wandelnden Effekte durch spezielle Motivwahl für Tageslicht und für Dunkelheit sind von großer Bedeutung für die Designmöglichkeiten.

Weiter können Fahrgastzellen in Transportmitteln, Autositze oder Ladeflächen in Kraftfahrzeugen durch Verwendung elektrolumineszierender Textilien zur Beleuchtung zugänglich werden.

Eine weitere Verwendung für Textilien mit elektrolumineszierenden Eigenschaften ergibt sich auf dem Gebiet der Sicherheitsbekleidung und technischen Anwendungen. Beispielsweise sind elektrolumineszierende Textilien in vorteilhafter Weise für warnende Sicherheitsbekleidung oder Wambekleidung verwendbar. Elektrolumineszierende Textilien bieten vielfältige Möglichkeiten für die Herstellung von Leuchteffekten auf Warn- und Sicherheitsbekleidung. Anwendungsmöglichkeiten reichen von Warnkleidung oder Sicherheitskleidung für Straßenarbeiter, Sanitäts- und Sicherheitsdienste und Polizei bis hin zu Schutzanzügen für die Feuerwehr und Accessoires wie Gürtel für Radfahrer und Jogger oder Schul- und Kindergartentaschen für Kinder und Schüler. Die besondere Eigenschaft der elektrolumineszierenden Textilien, insbesondere die Möglichkeit des Zuschaltens von Licht, beispielsweise als Warnhinweis, ermöglicht zusätzlich die Herstellung von unauffälliger Bekleidung für Sicherheitsbedienstete im Personenschutz, die sich bei Bedarf über ihre Kleidung identifizieren können.

Beispiele und Figuren, die der Veranschaulichung der vorliegenden Erfindung dienen, sind nachstehend angegeben.

In den Figuren zeigt:
- Fig. 1: eine schematische Darstellung der Schichtanordnung eines elektrolumineszierenden Textils;
- Fig. 2: eine Abbildung eines elektrolumineszierenden Textils unter angeschlossener Stromversorgung.

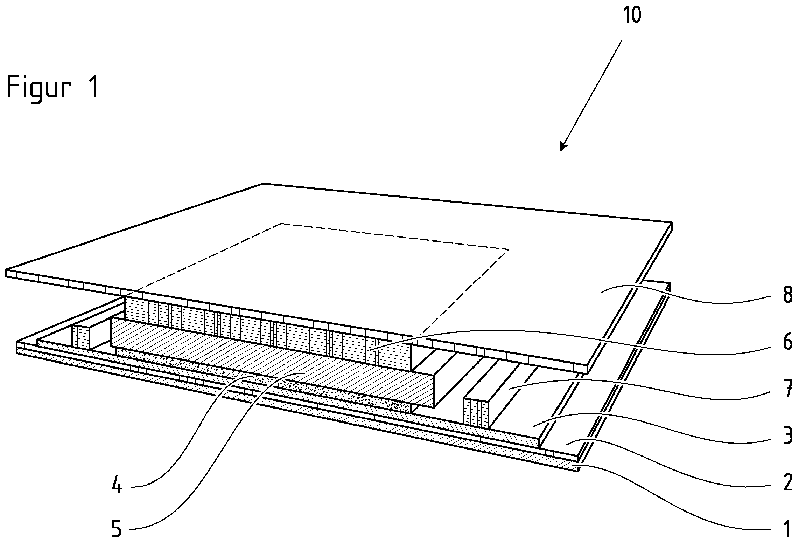

Gemäß der in Fig. 1 beispielhaft dargestellten schematischen Darstellung der Schichtanordnung eines elektrolumineszierenden Textils weist die Schichtanordnung 10 eines elektrolumineszierenden Textils ein Textilsubstrat 1, eine Schutzschicht 2, eine erste transparente leitfähige Schicht oder Frontelektrode 3, eine lichtemittierende Schicht 4, eine dielektrische Schicht 5, eine zweite leitfähige Schicht oder Rückelektrode 6, eine leitfähige Schiene 7 und eine Deckschicht 8 auf.

### Beispiel 1

Ein sehr dicht geschlagenes Segeltuchgewebe der Firma BW Industrial aus 100% Polyester mit einem Flächengewicht von 176 g/ m² und 45 Fd/ cm in Kett- und Schussrichtung diente als Grundware. Das Material wurde vorab mit 1 g/l nichtionogenem Waschmittel (Felosan RG-N, Fa. CHT) bei 95°C für 20 Minuten auf einem Jigger (Fa. E. Benz) entschlichtet. Hierbei wurden ca. 5 % Schlichteauflage zur Weiterbehandlung entfernt. Anschließend wurde das Material auf einem Labor-Trocken-Kondensier-Thermofixierapparat (Typ KTF/m 350, Fa. Mathis) bei 190°C für eine Minute thermofixiert.

Zur Mustergebung wurde die Gewebeoberseite mit einem geometrischen Muster per Siebdruck auf einem halbautomatischen Magnetrollrakeltisch (MDFR 242, Fa. J. Zimmer) mit Pigment-Druckpaste (Helizarin-Blau, Fa. BASF) bedruckt und erneut im Trockner (Fa. Mathis, Typ DHe) bei 130°C, eine Minute getrocknet.

Auf der Rückseite dieser vorbehandelten Gewebes wurden die verschiedenen Schichten der elektrolumineszierenden Schichtanordnung nacheinander auf einem Labor-Handstreichtisch (Typ GST 500, Fa. E. Benz) aufgetragen. Die erste transparente leitfähige Schicht, oder Frontelektrode wurde in Form einer transparenten leitfähigen Paste aus einer 3,4 Polyethylen-Dioxithiophen (PEDT)-Dispersion auf Basis eines synthetischen Polymers (Ormecon® EL 5602, Fa. Ormecon,) über eine Fläche von 25 cm x 30 cm in einer Schichtdicke von 8 µm aufgetragen und anschließend bei 130°C für 5 Minuten im Labor- Durchlauftrockner (Fa. E. Benz, Typ TKF15 M 500) getrocknet. Darauf wurde die lichtemittierende Schicht oder Phosphorschicht in Form einer Paste (Ormecon® EL 5400, Fa. Ormecon) über eine Fläche von 12 cm x 20 cm in einer Schichtdicke von 8 µm aufgetragen und bei 90°C für 5 Minuten getrocknet. Diese Schicht wurde danach vollständig überschichtet mit zwei Schichten einer dielektrischen Schicht. Das Dieletrikums wurde als Paste (Ormecon® EL 5500, Fa. Ormecon) über eine Fläche von 14 cm x 22 cm, jeweils in 15 µm Dicke aufgetragen, wobei die einzelnen Schichten jeweils bei 90°C für 5 Minuten zwischen getrocknet wurden.

Zuletzt wurden zwei Lagen einer zweiten leitfähigen Schicht aufgetragen. Die Rückelektrode wurde als Paste (Ormecon® EL 5800, Fa. Ormecon) über eine Fläche von 12 cm x 20 cm in einer Dicke von jeweils 20 µm aufgetragen und jeweils bei 90°C für 5 Minuten getrocknet. Abschließend wurde auf dem äußeren Rand der ersten transparenten leitfähigen Schicht oder Frontelektrode ähnlich einem Bilderrahmen eine so genannte Bus-bar, eine leitfähige Schiene, in einer Breite von ca. 1 cm und in einer Schichtdicke von 20 µm, mit der Paste der Rückelektrode aufgepinselt. Die Bus-bar berührte nur die Frontelektrode, um Kürzschlüsse zu vermeiden. Auch diese wurde bei 90°C für 5 Minuten getrocknet.

Anschließend wurde auf der Bus-Bar und auf der Rückelektrode jeweils ein 5 x 0,5 cm langes Kupferband aufgeklebt. Dieses Kupferband diente der gleichmäßigeren Verteilung der Spannung. Auf ein Kupferband wurden eine Phase des Stromkabel angeheftet, auf den anderen Streifen die andere Phase. Vor der Verbindung mit dem Inverter (Fa. Zigan, Typ EL-Sheet-Inverter, Modell LF 3312) und dem Stromnetz wurde das gesamte Muster rückseitig auf der Rückelektrode mit einer selbstklebenden Schutzfolie kalt laminiert.

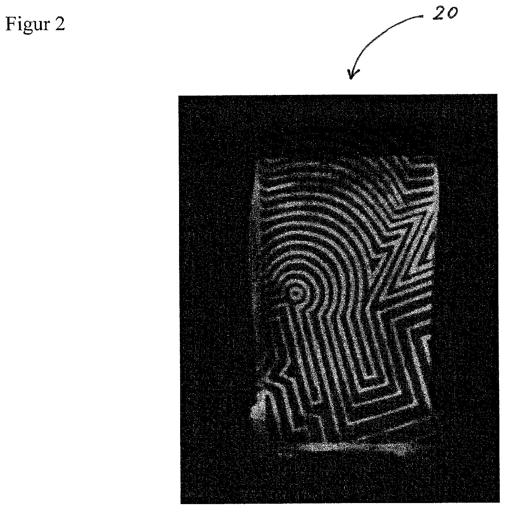

Wie in Fig. 2 dargestellt konnte festgestellt werden, dass das aufgebrachte geometrische Muster des elektrolumineszierenden Textils 20 flächig und hell leuchtend in hellem Türkisblau sichtbar war. Weiter wies das elektrolumineszierende Segeltuchgewebe eine nahezu identische Flexibilität der beschichteten und unbeschichteten Flächen auf.

### Beispiel 2

Ein sehr offenes farbiges Drehergewebe, hergestellt auf einem Easy- Leno Webstuhl an der Hochschule Niederrhein, aus 30 % Polyester/70 % Baumwolle mit einem Flächengewicht von 130 g/ m² und 23 Fd/ cm in Kett- und 40 Fd/ cm in Schussrichtung diente als Grundware.

Das Material wurde vorab mit 1 g/l nichtionogenem Waschmittel (Felosan RG-N, Fa. CHT) bei 95°C für 20 Minuten auf einem Jigger (Fa. E. Benz) entschlichtet. Hierbei wurden ca. 5 % Schlichteauflage zur Weiterbehandlung entfernt. Anschließend wurde das Gewebe auf einem Labor-Trocken-Kondensier-Thermofixierapparat (Typ KTF/m 350, Fa. Mathis) bei 190°C für 1 Minute thermofixiert. Die Mustergebung war durch die Webkonstruktion und die Auswahl farbiger Baumwollgarne im Schuss gegeben.

Die Beschichtungen der elektrolumineszierenden Schichtanordnung wurden nacheinander auf einem Labor-Handstreichtisch(Typ GST 500, Fa. E. Benz) durchgeführt. Getrocknet wurde das beschichtete Gewebe jeweils auf einem Labor- Durchlauftrockner (Fa. E. Benz, Typ TKF15 M 500).

Zum Schutz gegen Anschmutzung im Gebrauch wurde diese Ware zunächst auf der Warenoberseite mit einem nichtleitfähigen Silikon (Elastolsil LR 3003/30 A/B, Fa. Wacker,) in einer Schichtdicke von 10 µm beschichtet und bei 165°C für 5 Minuten getrocknet.

Zum Ausgleich einer relativ starken 3D-Struktur des Gewebes und zur Vermeidung von Durchschlägen von Schichten wurde auf der Rückseite der Ware eine "Schutz"-Schicht aus einem klaren Polyurethan-Polymer (Fa. CHT Tubicoat PUS + Verdicker Lutexal HIT) aufgetragen. Das Polyurethan-Polymer wurde in einer Schichtdicke von 15 µm ganzflächig aufgebracht und bei 140°C für 1 Minute kondensiert.

Die erste transparente Schicht oder Frontelektrode wurde in Form einer transparenten leitfähigen Paste (Ormecon® EL 5602, Fa. Ormecon,) über eine Fläche von 25 cm x 30 cm in einer Schichtdicke von 8 µm aufgetragen und bei 130°C für 5 Minuten getrocknet. Darauf wurde die Phosphorschicht in Form einer Paste (Ormecon® EL 5400, Fa. Ormecon) über eine Fläche von 12 cm x 20 cm in einer Schichtdicke von 8 µm aufgetragen und bei 90°C für 5 Minuten getrocknet. Diese Schicht wurde danach vollständig überschichtet mit zwei Schichten des Dieletrikums (Ormecon® EL 5500, Fa. Ormecon) über eine Fläche von 14 cm x 22 cm, jeweils in 15 µm Dicke. Die Schichten wurden jeweils bei 90°C für 5 Minuten zwischen getrocknet. Zuletzt wurden zwei Lagen der Rückelektrode als Paste (Ormecon® EL 5800, Fa. Ormecon) über eine Fläche von 12 cm x 20 cm in einer Dicke von jeweils 20 µm aufgetragen und jeweils bei 90°C für 5 Minuten getrocknet. Abschließend wurde auf dem äußeren Rand der Frontelektrode ähnlich einem Bilderrahmen eine Bus-Bar in einer Breite von ca. 1 cm und in einer Schichtdicke von 20 µm, mit der Paste der Rückelektrode aufgepinselt. Die Bus-bar berührte nur die Frontelektrode, um Kürzschlüsse zu vermeiden. Auch diese wurde bei 90°C für 5 Minuten getrocknet.

Anschließend wurde auf der Bus-Bar und auf der Rückelektrode jeweils ein 5 x 0,5 cm langes Kupferband aufgeklebt. Das Kupferband diente der gleichmäßigeren Verteilung der Spannung. Auf eines wurde eine Phase des Stromkabels angeheftet, auf den anderen Streifen die andere Phase. Vor der Verbindung mit dem Inverter (EL-Sheet-Inverter, Modell LF 3312, Fa. Zigan) und dem Stromnetz wurde das gesamte Muster rückseitig auf der Rückelektrode mit einer selbstklebenden Schutzfolie kalt laminiert.

Nach Anschließen an das Stromnetz konnte festgestellt werden, dass das hergestellte Muster ein gleichmäßiges, helles, blauweißes Leuchten zeigte. Weiterhin wurde die textile Optik des Gewebes im Leuchtbild integriert. Insbesondere konnte festgestellt werden, dass das hergestellte elektrolumineszierende Textil seine textile Haptik und Flexibilität erhielt.

## Patentansprüche

1. Verfahren zur Herstellung eines elektrolumineszierenden Textils umfassend die nachfolgenden Schritte:
a) Bereitstellen eines Textilsubstrats (1);
b) optional Aufbringen einer Schutzschicht (2) auf eine erste Oberfläche des Textilsubstrats (1);
c) Aufbringen einer ersten transparenten leitfähigen Schicht (3) auf die erste Oberfläche des Textilsubstrats oder die Schutzschicht (2);
d) Aufbringen wenigstens einer lichtemittierenden Schicht (4) auf die transparente leitfähige Schicht (3);
e) Aufbringen wenigstens einer dielektrischen Schicht (5) auf die lichtemittierende Schicht (4);
f) Aufbringen wenigstens einer zweiten leitfähigen Schicht (6) auf die dielektrische Schicht (5);
g) optional Anbringen von Anschlusselementen an den leitfähigen Schichten;
h) Aufbringen einer Deckschicht (8) auf die elektrolumineszierende Schichtanordnung; und
i) elektrisches Verbinden der ersten transparenten leitfähigen Schicht (3) und der zweiten leitfähigen Schicht (6) mit einer Spannungsquelle,
wobei man die elektrolumineszierende Schichtanordnung auf der Rückseite des Textils aufbringt und der Leuchtweg durch das Textil hindurch führt, und **dadurch gekennzeichnet, dass** man auf der ersten transparenten leitfähigen Schicht (3) eine leitfähige Schiene (7) umlaufend um die dielektrische Schicht (5) herum aufbringt, wobei die leitfähige Schiene (7) aus dem Material der zweiten leitfähigen Schicht (6) ausgebildet ist.

2. Verfahren nach Anspruch 1, **dadurch gekennzeichnet, dass** das Aufbringen einer Schicht durch kontinuierliches oder diskontinuierliches Beschichten erfolgt, vorzugsweise durch Streichen, Rakeln, Rollen, Walzen, Spritzen oder Tauchen, oder durch kontinuierliches oder diskontinuierliches Drucken, vorzugsweise durch Direktdruckverfahren ausgewählt aus der Gruppe umfassend Siebdruck, Rouleauxdruck, Digitaldruck und/oder Transferdruck.

3. Verfahren nach Anspruch 1 oder 2, **dadurch gekennzeichnet, dass** das Verfahren das Aufbringen eines Motivs, vorzugsweise durch Drucken und/oder Färben, auf eine zweite Oberfläche des Textilsubstrats (1) umfasst.

4. Verfahren nach einem der vorherigen Ansprüche, **dadurch gekennzeichnet, dass** man
- eine erste transparente leitfähige Schicht (3) mit einer Schichtdicke im Bereich von ≥ 2 µm bis ≤ 15 µm, vorzugsweise im Bereich von ≥ 5 µm bis ≤ 12 µm, bevorzugt im Bereich von ≥ 8 µm bis ≤ 10 µm, und/oder
- wenigstens eine lichtemittierende Schicht(en) (4) mit einer Gesamtschichtdicke im Bereich von ≥ 2 µm bis ≤ 20 µm, vorzugsweise im Bereich von > 5 µm bis ≤ 15 µm, bevorzugt im Bereich von ≥ 8 µm bis ≤ 12 µm, und/oder
- wenigstens eine dielektrische Schicht(en) (5) mit einer Gesamtschichtdicke im Bereich von ≥ 10 µm bis ≤ 50 µm, vorzugsweise im Bereich von ≥ 15 µm bis ≤ 40 µm, bevorzugt im Bereich von ≥ 20 µm bis ≤ 30 µm, und/oder
- wenigstens eine zweite leitfähige Schicht(en) (6) mit einer Gesamtschichtdicke im Bereich von ≥ 10 µm bis ≤ 80 µm, vorzugsweise im Bereich von ≥ 15 µm bis ≤ 50 µm, bevorzugt im Bereich von ≥ 20 µm bis ≤ 40 µm,
aufbringt.

5. Elektrolumineszierendes Textil umfassend:
- ein Textilsubstrat (1);
- optional eine Schutzschicht (2) auf einer ersten Oberfläche des Textilsubstrats (1);
- eine erste transparente leitfähige Schicht (3) auf der ersten Oberfläche des Textilsubstrats oder der Schutzschicht (2);
- wenigstens eine lichtemittierende Schicht (4) auf der transparenten leitfähigen Schicht (3);
- wenigstens eine dielektrische Schicht (5) auf der lichtemittierenden Schicht (4);
- wenigstens eine zweite leitfähige transparente oder nicht transparente Schicht (6) auf der dielektrischen Schicht (5);
- optional elektrische Anschlusselemente an den leitfähigen Schichten (3,6); und
- eine Deckschicht (8) auf der elektrolumineszierenden Schichtanordnung,
wobei die elektrolumineszierende Schichtanordnung auf der Rückseite des Textils angeordnet ist und der Leuchtweg durch das Textil hindurch führt, und **dadurch gekennzeichnet, dass** auf der ersten transparenten leitfähigen Schicht (3) eine leitfähige Schiene (7) umlaufend um die dielektrische Schicht (5) herum angeordnet ist, wobei die leitfähige Schiene (7) aus dem Material der zweiten leitfähigen Schicht (6) ausgebildet ist.

6. Elektrolumineszierendes Textil nach Anspruch 5, **dadurch gekennzeichnet, dass** das Textilsubstrat (1) einen Motivdruck auf einer zweiten Oberfläche umfasst.

7. Elektrolumineszierendes Textil nach einem der Ansprüche 5 bis 6, **dadurch gekennzeichnet, dass** die lichtemittierende Schicht ein- oder mehrfarbig ausgestaltete Motive aufweist.

8. Elektrolumineszierendes Textil nach einem der Ansprüche 5 bis 7, **dadurch gekennzeichnet, dass**
- die erste transparente leitfähige Schicht (3) eine Schichtdicke im Bereich von ≥ 2 µm bis ≤ 15 µm, vorzugsweise im Bereich von ≥ 5 µm bis ≤ 12 µm, bevorzugt im Bereich von ≥ 8 µm bis ≤ 10 µm; und/oder
- die wenigstens eine lichtemittierende Schicht(en) (4) eine Gesamtschichtdicke im Bereich von ≥ 2 µm bis ≤ 20 µm, vorzugsweise im Bereich von ≥ 5 µm bis ≤ 15 µm, bevorzugt im Bereich von ≥ 8 µm bis ≤ 12 µm; und/oder
- die wenigstens eine dielektrische Schicht(en) (5) eine Gesamtschichtdicke im Bereich von ≥ 10 µm bis ≤ 50 µm, vorzugsweise im Bereich von ≥ 15 µm bis ≤ 40 µm, bevorzugt im Bereich von ≥ 20 µm bis ≤ 30 µm, und/oder
- die wenigstens eine zweite leitfähige Schicht(en) (6) eine Gesamtschichtdicke im Bereich von ≥ 10 µm bis ≤ 80 µm, vorzugsweise im Bereich von ≥ 15 µm bis ≤ 50 µm, bevorzugt im Bereich von ≥ 20 µm bis ≤ 40 µm, aufweist.

9. Verwendung eines elektrolumineszierenden Textils gemäß einem der Ansprüche 5 bis 8 als Bekleidungsstück, Sicherheitstextil, Heimtextil oder als textile Leuchtfläche.

## Claims

1. A method for the production of an electroluminescent textile comprising the following steps:
a) providing a textile substrate (1);
b) optionally applying a protective layer (2) on a first surface of the textile substrate (1);
c) applying a first transparent conductive layer (3) on the first surface of the textile substrate or the protective layer (2);
d) applying at least one light emitting layer (4) on the transparent conductive layer (3);
e) applying at least one dielectric layer (5) on the light emitting layer (4);
f) applying at least a second conductive layer (6) on the dielectric layer (5);
g) optionally attaching connection elements to the conductive layers;
h) applying a top layer (8) on the electroluminescent layer arrangement; and
i) electrically connecting the first transparent conductive layer (3) and the second conductive layer (6) to an electric power supply,
wherein the electroluminescent layer arrangement is applied to the reverse side of the textile and the luminous path passes through the textile, and
**characterized in that** a conductive bar (7) is applied on the first transparent conductive layer (3), the conductive bar (7) extending around the dielectric layer (5), wherein the conductive bar (7) is made of the material of the second conductive layer(6).

2. The method according to claim 1, **characterized in that** a layer is applied by continuous or discontinuous coating, preferably by spreading, blade coating, web feeding, roller coating, spraying or dipping, or by continuous or discontinuous printing, preferably by means of direct printing methods selected from the group comprising screen printing, roller printing, digital printing and/or transfer printing.

3. The method according to claim 1 or 2, **characterized in that** the method comprises the application of a motif, preferably by means of printing and/or dyeing on a second surface of the textile substrate (1).

4. The method according to any one of the preceding claims, **characterized in that**:
- a first transparent conductive layer (3) having a layer thickness in the range from ≥ 2 µm to ≤ 15 µm, preferentially in the range from ≥ 5 µm to ≤ 12 µm, preferably in the range from ≥ 8 µm to ≤ 10 µm and/or
- at least one light emitting layer(s) (4) having a total layer thickness in the range from ≥ 2 µm to ≤ 20 µm, preferentially in the range from ≥ 5µm to ≤ 15 µm, preferably in the range from ≥ 8 µm to ≤ 12 µm, and/or
- at least one dielectric layer(s) (5) having a total layer thickness in the range from ≥ 10 µm to ≤ 50 µm, preferentially in the range from ≥ 15µm to ≤ 40 µm, preferably in the range from ≥ 20µm to ≤ 30 µm, and/or
- at least a second conductive layer(s) (6) having a total layer thickness in the range from ≥ 10 µm to ≤ 80 µm, preferentially in the range from ≥ 15µm to ≤ 50 µm, preferably in the range from ≥ 20 µm to ≤ 40 µm,
is applied.

5. An electroluminescent textile comprising:
- a textile substrate (1);
- optionally a protective layer (2) on a first surface of the textile substrate (1);
- a first transparent conductive layer (3) on the first surface of the textile substrate or the protective layer (2);
- at least one light emitting layer (4) on the transparent conductive layer (3);
- at least one dielectric layer (5) on the light emitting layer (4);
- at least one second conductive transparent or non-transparent layer (6) on the dielectric layer (5);
- optionally electrical connection elements attached to the conductive layers (3, 6); and
- a top layer (8) on the electroluminescent layer arrangement,
wherein the electroluminescent layer arrangement is applied to the reverse side of the textile and the luminous path passes through the textile, and
**characterized in that** a conductive bar (7) rests on the first transparent conductive layer (3), the conductive bar (7) extending around the dielectric layer (5), wherein the the conductive bar (7) is made of the material of the second conductive layer (6).

6. The electroluminescent textile according to claim 5, **characterized in that** the textile substrate (1) comprises a motif print on a second surface.

7. The electroluminescent textile according to any one of claim 5 to 6, **characterized in that** the light emitting layer comprises motifs configured in one or more colors.

8. The electroluminescent textile according to any one of claims 5 to 7, **characterized in that**
- the first transparent conductive layer (3) has a layer thickness in a range from ≥ 2 µm to ≤ 15 µm, preferentially in the range from ≥ 5 µm to ≤ 12 µm, preferably in the range from ≥ 8 µm to ≤ 10 µm and/or
- the at least one light emitting layer(s) (4) has a total layer thickness in a range from ≥ 2 µm to ≤ 20 µm, preferentially in the range from ≥ 5 µm to ≤ 15 µm, preferably in the range from ≥ 8 µm to ≤ 12 µm, and/or
- the at least one dielectric layer(s) (5) has a total layer thickness in a range from ≥ 10 µm to ≤ 50 µm, preferentially in the range from ≥ 15 µm to ≤ 40 µm, preferably in the range from ≥ 20 µm to ≤ 30 µm, and/or
- the at least second conductive layer(s) (6) has a total layer thickness in a range from ≥ 10 µm to ≤ 80 µm, preferentially in the range from ≥ 15µm to ≤ 50 µm, preferably in the range from ≥ 20 µm to ≤ 40 µm.

9. Use of a textile according to any one of claims 5 to 8 as an article of clothing, a safety textile, a household textile or as a luminous textile surface.

## Revendications

1. Procédé de fabrication d'un textile électroluminescent, comprenant les étapes suivantes :
a) fourniture d'un substrat en textile (1) ;
b) application facultative d'une couche de protection (2) sur une première surface du substrat en textile (1) ;
c) application d'une première couche conductrice (3) transparente sur la première surface du substrat en textile (1) ou sur la couche de protection (2) ;
d) application d'au moins une couche émettrice de lumière (4) sur la couche conductrice (3) transparente ;
e) application d'au moins une couche diélectrique (5) sur la couche émettrice de lumière (4) ;
f) application d'au moins une deuxième couche conductrice (6) sur la couche diélectrique (5) ;
g) application facultative d'éléments de raccordement sur les couches conductrices ;
h) application d'une couche de recouvrement (8) sur l'arrangement de couches électroluminescent ; et
i) connexion électrique de la première couche conductrice (3) transparente et de la deuxième couche conductrice (6) à une source de tension,
l'arrangement de couches électroluminescent étant appliqué sur le côté arrière du textile et le trajet lumineux passant à travers le textile, et
**caractérisé en ce que**
une bande conductrice (7) est appliquée sur la première couche conductrice (3) transparente de manière circulaire autour de la couche diélectrique (5), la bande conductrice (7) étant réalisée dans le matériau de la deuxième couche conductrice (6).

2. Procédé selon la revendication 1, **caractérisé en ce que** l'application d'une couche s'effectue par couchage continu ou discontinu, de préférence par enduction, raclage, roulage, laminage, pulvérisation ou trempage, ou par impression continue ou discontinue, de préférence par un procédé d'impression direct choisi dans le groupe comprenant la sérigraphie, l'impression aux rouleaux, l'impression numérique et/ou l'impression par transfert.

3. Procédé selon la revendication 1 ou 2, **caractérisé en ce que** le procédé comprend l'application d'un motif, de préférence par impression et/ou coloration, sur une deuxième surface du substrat en textile (1).

4. Procédé selon l'une des revendications précédentes, **caractérisé en ce que**
- une première couche conductrice (3) transparente est appliquée avec une épaisseur de couche comprise dans la plage de ≥ 2 µm à ≤ 15 µm, de préférence dans la plage de ≥ 5 µm à ≤ 12 µm, préférablement dans la plage de ≥ 8 µm à ≤ 10 µm, et/ou
- au moins une couche émettrice de lumière (4) est appliquée avec une épaisseur de couche totale comprise dans la plage de ≥ 2 µm à ≤ 20 µm, de préférence dans la plage de ≥ 5 µm à ≤ 15 µm, préférablement dans la plage de ≥ 8 µm à ≤ 12 µm, et/ou
- au moins une couche diélectrique (5) est appliquée avec une épaisseur de couche totale comprise dans la plage de ≥ 10 µm à ≤ 50 µm, de préférence dans la plage de ≥ 15 µm à ≤ 40 µm, préférablement dans la plage de ≥ 20 µm à ≤ 30 µm, et/ou
- au moins une deuxième couche conductrice (6) est appliquée avec une épaisseur de couche totale comprise dans la plage de ≥ 10 µm à ≤ 80 µm, de préférence dans la plage de ≥ 15 µm à ≤ 50 µm, préférablement dans la plage de ≥ 20 µm à ≤ 40 µm.

5. Textile électroluminescent, comprenant :
- un substrat en textile (1) ;
- facultativement une couche de protection (2) sur une première surface du substrat en textile (1) ;
- une première couche conductrice (3) transparente sur la première surface du substrat en textile ou sur la couche de protection (2) ;
- au moins une couche émettrice de lumière (4) sur la couche conductrice (3) transparente ;
- au moins une couche diélectrique (5) sur la couche émettrice de lumière (4) ;
- au moins une deuxième couche conductrice (6) transparente ou non transparente sur la couche diélectrique (5) ;
- des éléments de raccordement électriques facultatifs sur les couches conductrices (3, 6) ; et
- une couche de recouvrement (8) sur l'arrangement de couches électroluminescent ;
l'arrangement de couches électroluminescent étant disposé sur le côté arrière du textile et le trajet lumineux passant à travers le textile, et
**caractérisé en ce que**
une bande conductrice (7) est appliquée sur la première couche conductrice (3) transparente de manière circulaire autour de la couche diélectrique (5), la bande conductrice (7) étant réalisée dans le matériau de la deuxième couche conductrice (6).

6. Textile électroluminescent selon la revendication 5, **caractérisé en ce que** le substrat en textile (1) comprend une impression de motif sur une deuxième surface.

7. Textile électroluminescent selon l'une des revendications 5 à 6, **caractérisé en ce que** la couche émettrice de lumière possède un ou plusieurs motifs monochromes ou multicolores.

8. Textile électroluminescent selon l'une des revendications 5 à 7, **caractérisé en ce que**
- la première couche conductrice (3) transparente présente une épaisseur de couche comprise dans la plage de ≥ 2 µm à ≤ 15 µm, de préférence dans la plage de ≥ 5 µm à ≤ 12 µm, préférablement dans la plage de ≥ 8 µm à ≤ 10 µm ; et/ou
- l'au moins une couche émettrice de lumière (4) présente une épaisseur de couche totale comprise dans la plage de ≥ 2 µm à ≤ 20 µm, de préférence dans la plage de ≥ 5 µm à ≤ 15 µm, préférablement dans la plage de ≥ 8 µm à ≤ 12 µm ; et/ou
- l'au moins une couche diélectrique (5) présente une épaisseur de couche totale comprise dans la plage de ≥ 10 µm à ≤ 50 µm, de préférence dans la plage de ≥ 15 µm à ≤ 40 µm, préférablement dans la plage de ≥ 20 µm à ≤ 30 µm, et/ou
- l'au moins une deuxième couche conductrice (6) présente une épaisseur de couche totale comprise dans la plage de ≥ 10 µm à ≤ 80 µm, de préférence dans la plage de ≥ 15 µm à ≤ 50 µm, préférablement dans la plage de ≥ 20 µm à ≤ 40 µm.

9. Utilisation d'un textile électroluminescent selon l'une des revendications 5 à 8 comme pièce de vêtement, textile de sécurité, textile pour la maison ou en tant que surface lumineuse textile.
